# EUROPEAN PATENT APPLICATION

(11) **EP 4 580 375 A1**
(43) Date of publication of application: **02.07.2025**
(21) Application number: 24210537.7
(22) Date of filing: 04.11.2024
(51) Int. Cl.: H10K 59/40, H10K 59/65, H10K 59/80, H10K 59/88

(54) **DISPLAY PANEL AND DISPLAY DEVICE INCLUDING THE SAME**

(30) Priority: 29.12.2023 KR 20230197833
(71) Applicant: LG Display Co., Ltd., Seoul 07336 (KR)
(72) Inventor: PAEK, Seung Han, 10845 Paju-si, Gyeonggi-do (KR); PARK, Yong In, 10845 Paju-si, Gyeonggi-do (KR); YOON, Kyung Jae, 10845 Paju-si, Gyeonggi-do (KR); HAN, Jeon Phill, 10845 Paju-si, Gyeonggi-do (KR); KIM, Nam Woo, 10845 Paju-si, Gyeonggi-do (KR)
(74) Representative: Viering, Jentschura & Partner mbB Patent- und Rechtsanwälte

(57) **Abstract**

The present disclosure relates to a display panel (100) and display device including the same. The display device including a display panel (100) including a display area (DA), a light-transmissive area, and a non-display area (NDA) surrounding the light-transmissive area. The display panel (100) includes a substrate (10) disposed in the display area (DA) and the non-display area (NDA), a circuit part (13) disposed on the substrate (10), a light-emitting element part (15) disposed on the circuit part (13), an encapsulation part (17) disposed on the light-emitting element part (15), and a touch part (18) disposed on the encapsulation part (17). An organic insulating layer extending from the touch part (18) is disposed on the opening (11) formed in the substrate (10).

## Description

### CROSS-REFERENCE TO RELATED APPLICATION

This application claims priority to and the benefit of Korean Patent Application No. 10-2023-0197833, filed December 29, 2023.

### Technical Field

The present disclosure relates to a display panel and display device including the same, and more particularly, for example, without limitation, to a display panel structurally improved in order to prevent moisture penetration prevention, and a display device including the same.

### Description of Related Art

Electroluminescence display devices are classified into inorganic light-emitting display devices and organic light-emitting display devices depending on materials of an emission layer. An active-matrix-type organic light-emitting display device includes an organic light-emitting diode (OLED) that emits light by itself and has advantages of a quick response time, high light emission efficiency, high luminance, and a wide viewing angle. The organic light-emitting display device has OLEDs formed in each pixel. The organic light-emitting display device may represent a black grayscale as perfect black as well as having a quick response time, high light emission efficiency, high luminance, and a wide viewing angle, and thus has an excellent contrast ratio and color gamut.

The description provided in the discussion of the related art section should not be assumed to be prior art merely because it is mentioned in or associated with that section. The discussion of the related art section may include information that describes one or more aspects of the subject technology, and the description in this section does not limit the disclosure.

### SUMMARY

Recently, an organic light-emitting display device has been implemented on a plastic substrate made of a flexible material, but may also be implemented on a glass substrate due to various issues.

However, when a laser is used in order to form a notch on a glass substrate or a hole inside a display panel, the display panel may be damaged by the laser, or some moisture, oxygen, or the like may penetrate into the interior of the display panel due to such damage.

At least one example embodiment of the present disclosure provides a display panel that improves quality and reliability by preventing film lifting when a light-transmissive area is formed, and a display device including the same.

At least one example embodiment of the present disclosure provides a display panel structurally improved in order to prevent moisture penetration prevention, and a display device including the same.

At least one example embodiment of the present disclosure provides a display panel that maintains rigidity while forming various shapes of holes in a glass substrate, and a display device including the same.

Objectives to be solved by embodiments of the present disclosure are not limited to the objectives described above, and objectives which are not described above will be clearly understood by those skilled in the art from the following descriptions. According to an aspect of the present disclosure, a display device according to claim 1 is provided. Further embodiments are described in the dependent claims.

A display device according to at least one example embodiment of the present disclosure includes a display panel including a display area, a light-transmissive area, and a non-display area surrounding the light-transmissive area, wherein the display panel includes a substrate disposed in the display area and the non-display area, a circuit part disposed on the substrate, a light-emitting element part disposed on the circuit part, an encapsulation part disposed on the light-emitting element part, and a touch part disposed on the encapsulation part, wherein the substrate and the encapsulation part surround an opening disposed corresponding to the light-transmissive area, and an organic insulating layer is disposed on the opening.

A display device according to at least one example embodiment of the present disclosure includes a display panel comprising a display area, a light-transmissive area, and a non-display area surrounding the light-transmissive area, wherein the display panel includes a substrate disposed in the display area and the non-display area, a circuit part disposed on the substrate, a light-emitting element part disposed on the circuit part, an encapsulation part disposed on the light-emitting element part, and a touch part disposed on the encapsulation part, wherein the substrate includes an opening disposed corresponding to the light-transmissive area, and one of a first touch planarization layer and a second touch planarization layer of the touch part extending toward the light-transmissive area is bonded to a coating layer disposed in the opening.

A display device according to at least one example embodiment of the present disclosure includes a display panel comprising a display area, a light-transmissive area, and a non-display area surrounding the light-transmissive area, wherein the display panel includes a substrate disposed in the display area and the non-display area, a circuit part disposed on the substrate, a light-emitting element part disposed on the circuit part, an encapsulation part disposed on the light-emitting element part, and a touch part disposed on the encapsulation part, wherein the substrate includes an opening disposed corresponding to the light-transmissive area, the non-display area includes a wire area where a wire that bypasses the light-transmissive area is disposed, a dummy area surrounding the light-transmissive area, and a moisture penetration prevention area disposed between the wire area and the dummy area, the moisture penetration prevention area includes a first moisture penetration prevention structure and a second moisture penetration prevention structure spaced apart from each other, and one of a first touch planarization layer and a second touch planarization layer of the touch part extending from the touch part toward the light-transmissive area is disposed between the first moisture penetration prevention structure and the second moisture penetration prevention structure.

According to one or more aspects of the present disclosure, layer peeling may be prevented from occurring around a light-transmissive area by bonding a coating layer made of an organic material disposed in an opening of a display panel and an organic insulating layer disposed on the opening. In addition, the bonding of the coating layer and the organic insulating layer may prevent moisture, oxygen, or the like from penetrating into the interior of the display panel through the light-transmissive area. Specifically, a planarization layer extending from a touch part of a display area to the light-transmissive area is used as an organic insulating layer bonded to the coating layer, thereby preventing layer peeling that may occur between a plurality of layers disposed between the substrate and the planarization layer of the touch part and preventing moisture, oxygen, or the like from penetrating into the interior of the display panel through the light-transmissive area. Consequently, the quality and reliability of the display panel may be improved.

According to one or more aspects of the present disclosure, moisture, oxygen, or the like may be prevented from penetrating into the interior of the display panel by disposing a moisture penetration prevention structure in a non-display area disposed between the display area and the light-transmissive area.

According to one or more aspects of the present disclosure, process optimization may be implemented by etching a part of a glass substrate through an etching process of simultaneously forming various shapes of holes.

According to one or more aspects of the present disclosure, when a substrate made of glass is etched, a planarization layer made of an organic material and extending from the touch part of the display area to the light-transmissive area is used as an anti-etching layer, thereby preventing an etching solution from penetrating into the interior of the display panel.

Various useful advantages and effects of the present disclosure are not limited to the above-described contents, and effects which are not described above will be clearly understood by those skilled in the art from the following descriptions.

It is to be understood that both the foregoing general description and the following detailed description of the present disclosure are example and explanatory and are intended to provide further explanation of the disclosure as claimed.

### BRIEF DESCRIPTION OF THE DRAWINGS

The above and other objects, features and advantages of the present disclosure will become more apparent to those of ordinary skill in the art by describing example embodiments thereof in detail with reference to the attached drawings, in which:
FIG. 1 is a view illustrating a display device according to an example embodiment of the present disclosure;
FIG. 2 is a cross-sectional view taken along line I-I' in FIG. 1;
FIG. 3 is an enlarged view of a part A in FIG. 2;
FIG. 4 is a cross-sectional view taken along line II-II' in FIG. 1;
FIG. 5 is a view illustrating a light-transmissive area and a first protrusion surrounding an edge area of the light-transmissive area;
FIG. 6 is an enlarged view illustrating an area B in FIG. 5;
FIG. 7 is an enlarged view illustrating an area Ba in FIG. 6;
FIG. 8 is a view illustrating an example of a display panel disposed in a display device according to an example embodiment of the present disclosure;
FIG. 9 is an enlarged view illustrating an area D in FIG. 8;
FIG. 10 is an enlarged view illustrating an area E in FIG. 8;
FIG. 11 is an enlarged view illustrating an area F in FIG. 8;
FIGS. 12A to 12H are views illustrating a process of forming a light-transmitting area in the display panel illustrated in FIG. 8 according to an example of the present disclosure;
FIG. 13 is a view illustrating another example of a display panel disposed in a display device according to an example embodiment of the present disclosure;
FIG. 14 is an enlarged view illustrating an area G in FIG. 13;
FIGS. 15A to 15H are views illustrating a process of forming a light-transmitting area in the display panel illustrated in FIG. 13 according to an example of the present disclosure;
FIG. 16 is a view illustrating further another example of a display panel disposed in a display device according to an example embodiment of the present disclosure;
FIG. 17 is an enlarged view illustrating an area H in FIG. 16; and
FIGS. 18A to 18H are views illustrating a process of forming a light-transmitting area in the display panel illustrated in FIG. 16 according to an example of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF EXEMPLARY EMBODIMENTS

Reference will now be made in detail to embodiments of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

The advantages and features of the present disclosure and methods for accomplishing the same will be more clearly understood from embodiments described below with reference to the accompanying drawings. However, the present disclosure is not limited to the following example embodiments but may be implemented in various different forms. Rather, the present embodiments will make the disclosure of the present disclosure complete and allow those skilled in the art to completely comprehend the scope of the present disclosure. The present disclosure is only defined within the scope of the accompanying claims.

Shapes, sizes, ratios, angles, numbers, and the like disclosed in the drawings for describing the embodiments of the present disclosure are exemplary, and the present disclosure is not limited to the illustrated items. Like reference numerals refer to like elements throughout. In addition, in describing the present disclosure, if it is determined that the detailed description of the related known technology may unnecessarily obscure the subject matter of the present disclosure, the detailed description thereof will be omitted.

The terms such as "comprising", "including", "having" and "consisting of" "make up of," "formed of," and the like used herein are generally intended to allow other components to be added unless the terms are used with the term "only". References to the singular shall be construed to include the plural unless expressly stated otherwise.

In interpreting a component, it is interpreted to include an error range even if there is no separate description. Any implementation described herein as an "example" is not necessarily to be construed as preferred or advantageous over other implementations.

When describing a positional or interconnected relationship between two components, such as "on top of", "above", "below", "next to", "connect or couple with", "crossing", "intersecting" etc., one or more other components may be interposed between them unless "immediately" or "directly" is used, that is, one or more other parts may be disposed located between the two parts. For example, where an element or layer is disposed "on" another element or layer, a third layer or element may be interposed therebetween.

When describing a temporal contextual relationship is described, such as "after", "following", "next to" or "before", it may not be continuous on a time scale unless "immediately" or "directly" is used.

To distinguish between components, ordinal numbers such as first, second, "A" "B" "(A)" or "(B)" and the like may be used before the name of the component, but the function or structure is not limited by these ordinal numbers or component names. For convenience of description, different embodiments may have different ordinal numbers preceding the names of the same component.

The following embodiments may be combined or associated with each other in whole or in part, and various types of interlocking and driving are technically possible. The example embodiments may be implemented independently of each other or together in an interrelated relationship.

The term "at least one" should be understood as including any and all combinations of one or more of the associated listed items. For example, the meaning of "at least one of a first element, a second element, and a third element" compasses the combination of all three listed elements, combinations of any two of the three elements, as well as each individual element, the first element, the second element, or the third element.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

The features of the various embodiments of the present disclosure may be partially or entirely combined with each other, and may be technically associated with each other or operate with each other. The embodiments may be implemented independently of each other and may be implemented together in an association relationship.

Hereinafter, the various embodiments of the present disclosure will be described in detail with reference to the accompanying drawings. The scales of the components shown in the drawings have different scales from the actual ones for convenience of explanation, and thus are not limited to the scales shown in the drawings. All the components of each device/apparatus according to all embodiments of the present disclosure are operatively coupled and configured.

Throughout the disclosure, the same reference numerals refer to the same component.

As used herein, "a display device" may include a display device in a narrow sense, such as a liquid crystal module (LCM), an organic light-emitting diode (OLED) module, or a quantum dot (QD) module, which includes a display panel and a driver for driving the display panel. It may also include a set electronic apparatus or a set device or set apparatus, such as a laptop computer, a television set, a computer monitor, an automotive display apparatus or an equipment display apparatus including another form in a vehicle, and a mobile electronic apparatus, such as a smart phone or an electronic pad, which is a complete product or finished product including the LCM, the OLED module, and the QD module.

A display device in this disclosure may include a display device itself in a narrow sense, an application product including a display in a narrow sense, or even a set device that is an end-consumer device.

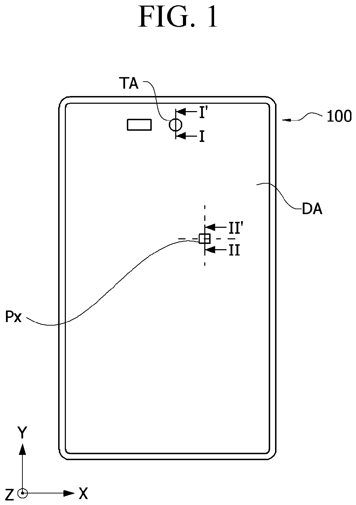

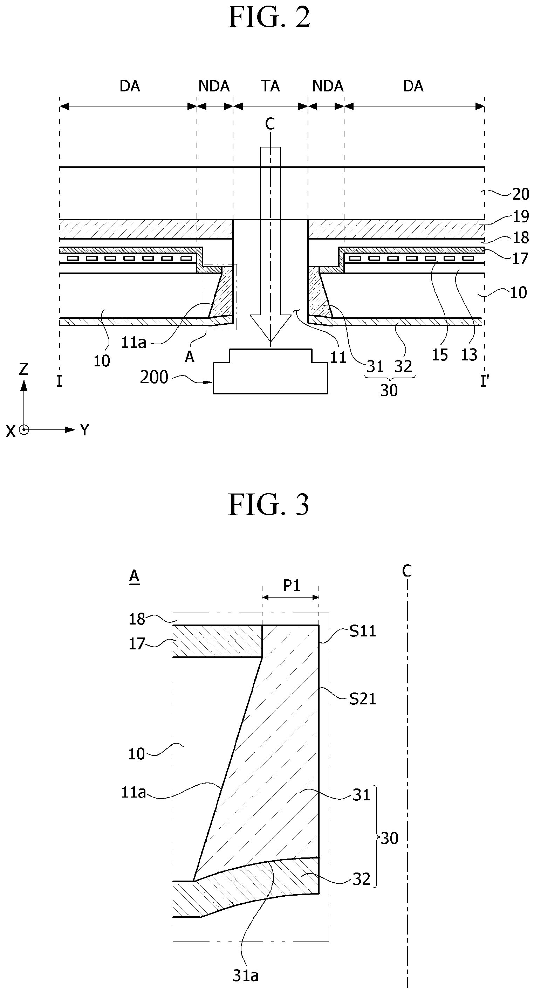

FIG. 1 is a conceptual view of a display device according to an example embodiment of the present disclosure, FIG. 2 is a cross-sectional view taken along line I-I' in FIG. 1, and FIG. 3 is an enlarged view of a part A in FIG. 2. In FIG. 2, reference numeral C indicating a virtual line may indicate the center of a light-transmissive area TA.

Referring to FIGs. 1 and 2, the display device according to an example embodiment of the present disclosure may include a display panel 100 on which an input image is visually reproduced, and a sensor 200 disposed corresponding to the light-transmissive area TA of the display panel 100. Embodiments are not limited thereto. As an example, at least one of the above-mentioned components may be omitted, and/or one or more additional components could be further included.

The display panel 100 may include a display area DA where an image is displayed, the light-transmissive area TA where light is incident, and a non-display area NDA formed between the light-transmissive area TA and the display area DA, without being limited thereto. The light-transmissive area TA may be a hole structure for allowing light to enter the sensor 200 disposed below the display panel 100, but is not necessarily limited thereto. The non-display area NDA may be an area where no image is displayed, unlike the display area DA.

The display panel 100 may be a panel with a rectangular structure having a width in an X-axis direction, a length in a Y-axis direction, and a thickness in a Z-axis direction. The width and length of the display panel 100 may be set to various design values depending on the application field of the display device. The X-axis direction may refer to a width direction, a row direction, or a horizontal direction, the Y-axis direction may refer to a longitudinal direction, a column direction, or a vertical direction, and the Z-axis direction may refer to an up-down direction or a thickness direction, without being limited thereto. The X-axis direction, the Y-axis direction, and the Z-axis direction may be perpendicular to one another, but may also refer to different directions that are not perpendicular to one another. Accordingly, each of the X-axis direction, the Y-axis direction, and the Z-axis direction may be described as one of a first direction, a second direction, and a third direction. A surface extending in the X-axis direction and the Y-axis direction may refer to a horizontal surface. A surface extending in the Z-axis direction may refer to a vertical surface.

In the display area DA of the display panel 100, data lines, gate lines crossing the data lines, and a plurality of pixels Px arranged in a matrix form defined by the data lines and the gate lines may be disposed, without being limited thereto. Alternatively, more or less elements may be disposed.

Each of the plurality of pixels Px includes subpixels of different colors for color reproduction. For example, the subpixels may include a red subpixel, a green subpixel, and a blue subpixel, without being limited thereto. Alternatively, the subpixels may include a cyan subpixel, magenta subpixel, or yellow subpixel, etc. Although not illustrated, each of the plurality of pixels Px may further include subpixels of same color. For example, the subpixels may include a white subpixel, without being limited thereto. Hereinafter, the pixel may be interpreted as a subpixel unless otherwise defined. Each of the subpixels may include a pixel circuit.

As one example, the pixel circuit may include a light-emitting element, a driving element that supplies a current to the light-emitting element, one or more switch elements that switch current paths of the driving element and the light-emitting element, a capacitor that maintains a voltage Vgs between a gate and a source of the driving element, and the like.

The light-emitting element may be implemented in an element structure such as an organic light-emitting diode (OLED) display, a quantum dot display, and a micro light-emitting diode (LED) display, without being limited thereto. Hereinafter, an OLED structure including an organic compound layer will be described as an example.

An OLED includes an anode electrode, a cathode electrode and an organic compound layer formed between the anode electrode and the cathode electrode. The organic compound layer may include one or more of a hole injection layer (HIL), a hole transport layer (HTL), an emission layer (EML), an electron transport layer (ETL), and an electron injection layer (EIL), but is not limited thereto. When a voltage is applied to the anode electrode and the cathode electrode of the OLED, holes passing through the hole transport layer (HTL) and electrons passing through the electron transport layer (ETL) are moved to the emission layer (EML) to form excitons, so that visible light is emitted from the emission layer (EML).

A display panel driver writes pixel data of an input image into the pixels Px. The display panel driver may include a data driver that supplies a data voltage of the pixel data to the data lines, and a gate driver that sequentially supplies a gate pulse to the gate lines, and so on. The data driver is integrated into a drive IC. The drive IC may be attached onto the display panel 100.

The drive IC is connected to the data lines through data output channels and supplies a voltage of a data signal to the data lines. The drive IC includes a timing controller. The timing controller transmits pixel data of an input image received from a host system to the data driver, and controls the operation timing of the data driver and the gate driver.

The data driver of the drive IC converts pixel data into a gamma compensation voltage through a digital to analog converter (DAC), and outputs a data voltage.

The gate driver may include a shift register formed in a circuit layer of the display panel 100 along with a pixel array. The shift register of the gate driver sequentially supplies a gate signal to the gate lines under the control of the timing controller. The gate signal may include a scan pulse and an emission control pulse (hereinafter, referred to as an "EM pulse"). The shift register may include a scan driver that outputs a scan pulse and an EM driver that outputs an EM pulse, and so on.

The host system may be implemented as an application processor (AP). The host system transmits pixel data of an input image to the drive IC. The host system may be connected to the drive IC through a flexible printed circuit, for example, a flexible printed circuit (FPC).

Various wiring and driving circuits may be disposed in the non-display area NDA, and a pad part to which an integrated circuit, a printed circuit, and the like are connected may be disposed.

The flexible printed circuit may be formed on a flexible printed circuit board and may be connected to the drive IC through the pad part. The drive IC may be disposed on the display panel 100, but is not necessarily limited thereto. For example, the drive IC may also be disposed on the flexible printed circuit board.

The display panel 100 may be manufactured based on a glass substrate, but is not necessarily limited thereto. Alternatively, the display panel 100 may be manufactured based on a plastic, or a flexible polymer film. For example, the flexible polymer film may be made of any one of polyethylene terephthalate(PET), polycarbonate(PC), acrylonitrile-butadienestyrene copolymer(ABS), polymethyl methacrylate(PMMA), polyethylene naphthalate(PEN), polyether sulfone(PES), cyclic olefin copolymer(COC), triacetylcellulose(TAC) film, polyvinyl alcohol(PVA) film, polyimide(PI) film, and polystyrene(PS), which is only an example and is not necessarily limited thereto.

Referring to FIG. 2, the display panel 100 may include a substrate 10 disposed in the display area and the non-display area, a circuit part 13 disposed on the substrate 10 and a light-emitting element part 15 disposed on the circuit part 13, without being limited thereto. The display panel 100 may further include an encapsulation part 17 disposed on the light-emitting element part 15, a polarizer 19 disposed on the encapsulation part 17, and a cover glass 20 disposed on the polarizer 19. The display panel may further include a touch part 18 disposed between the light-emitting element part 15 and the polarizer 19. Specifically, the touch part 18 may be disposed between the encapsulation part 17 and the polarizer 19.

The substrate 10 may be made of an insulating material or a material with flexibility, without being limited thereto. For example, the substrate 10 may be made of glass, metal, or plastic, but is not limited thereto. However, as the substrate 10, a glass substrate having a certain strength may be used for an etching process for process simplification.

The circuit part 13 may include the pixel circuit connected to wirings such as the data lines, the gate lines, and power lines, the gate driver connected to the gate lines, and the like. Additionally, the wiring of the circuit part 13 may include a plurality of insulating layers, two or more metal layers separated with the insulating layer therebetween, and an active layer including a semiconductor material, and so on. The circuit element of the circuit part 13 may include a transistor implemented as a thin film transistor (TFT) and a capacitor, and so on.

The light-emitting element part 15 may include light-emitting elements driven by the pixel circuit, without being limited thereto. Alternatively, the light-emitting element part 15 may further include a color filter array disposed on the light -emitting elements. The light-emitting elements may include a plurality of light-emitting elements, such as a red light-emitting element, a green light-emitting element, and a blue light-emitting element. In another embodiment, the light-emitting element part 15 may include a white light-emitting element and a color filter. The light-emitting elements of the light-emitting element part 15 may be covered with a protective layer including an organic film and a protective film.

The light-emitting element part 15 may further include a color filter array disposed on pixels that selectively transmit red, green, and blue wavelengths, without being limited thereto.

The encapsulation part 17 covers the light-emitting element part 15 to seal the circuit part 13 and the light-emitting element part 15. The encapsulation part 17 may have a multi-insulating film structure in which an organic film and an inorganic film are alternately stacked. The inorganic film may block the penetration of moisture or oxygen. The organic film may planarize the surface of the inorganic film. When the organic film and the inorganic film are stacked in multiple layers, a movement path of moisture or oxygen becomes longer compared to a single layer, so that the penetration of moisture/oxygen affecting the light-emitting element part 15 may be effectively blocked.

The touch part 18 may include capacitive touch sensors that sense a touch input based on a change in capacitance before and after the touch input. The touch part 18 may include metal wiring patterns and insulating films that form the capacitance of the touch sensors. The insulating films may insulate intersection portions of the metal wiring patterns and planarize the surface of the touch part.

The polarizer 19 may be disposed on the light-emitting element part 15. Specifically, the polarizer 19 may be disposed on the touch part 18. The polarizer 19 may improve the outdoor visibility of the display device. For example, the polarizer 19 may improve visibility and contrast ratio by converting the polarization of external light reflected by metal patterns of the circuit part 13. The polarizer 19 may be implemented as a polarizer or a circular polarizer in which a linear polarizer and a phase retardation film are bonded. The cover glass 20 may be attached onto the polarizer 19.

The light-transmissive area TA may be formed in the display area DA. The non-display area NDA may be disposed to surround the light-transmissive area TA. The non-display area NDA may have a plurality of dam structures to protect the light-emitting elements in the display area DA from moisture, oxygen, or the like that may enter from the light-transmissive area TA.

The light-transmissive area TA may have a through-hole structure for injecting light into the sensor 200 such as a camera, but is not necessarily limited thereto. For example, pixels with low density may be disposed in the light-transmissive area TA.

The substrate 10 may include an opening 11 disposed in the light-transmissive area TA. For example, the substrate 10 and the encapsulation part 17 may surround an opening 11 disposed corresponding to the light-transmissive area TA. The opening 11 may have a tapered shape whose width becomes narrower toward the cover glass 20, but is not necessarily limited thereto. For example, the opening 11 may be formed in a tapered shape whose width becomes wider toward the cover glass 20, or may be formed in a cylindrical shape with a constant width. For example, the shape of the opening 11 may be variously changed depending on the type of etching solution and an etching method.

An organic insulating layer may be disposed on the opening 11 of the substrate 10. The opening 11 in the display panel 100 may be provided as a concave groove formed on the back surface of the display panel 100, and the organic insulating layer may be referred to as an organic insulating member or an organic insulating film.

The organic insulating layer disposed on the opening 11 may prevent an etching solution from penetrating into the interior of the display panel 100 during an etching process. Accordingly, the organic insulating layer disposed on the opening 11 may be referred to as an anti-etching layer.

The organic insulating layer may include an organic material that is resistant to an etching solution. For example, the organic insulating layer may include one selected from the group consisting of polyester-based polymers, silicone-based polymers, acrylic-based polymers, polyolefin-based polymers, and copolymers thereof. However, it is not necessarily limited thereto, and the organic insulating layer disposed on the opening 11 may include various materials such as an inorganic material or a metal material that is resistant to an etching solution.

In consideration of process efficiency and layer peeling that may occur between a plurality of layers extending to the light-transmissive area TAfrom a plurality of layers disposed between the substrate and the touch part, the organic insulating layer may be formed by extending at least one of layers constituting the touch part 18. As illustrated in FIG. 2, the organic insulating layer may be formed as one of layers extending from the touch part 18 of the display area DA toward the light-transmissive area TA, without being limited thereto. For example, the organic insulating layer may be one of a first touch planarization layer and a second touch planarization layer extending from the touch part 18 toward the light-transmissive area TA.

For example, the organic insulating layer disposed on the opening 11 may be a dummy layer of the touch part 18. According to such a configuration, the organic insulating layer may be formed without adding a separate process. The organic insulating layer is, for example, formed by extending at least one of the layers constituting the touch part 18, and may be formed together in a process of forming at least one of the layers constituting the touch part 18, but is not necessarily limited thereto. For example, the organic insulating layer disposed on the opening 11 may be formed by extending from at least one of layers constituting the encapsulation part 17, and may be formed together in a process of forming at least one of the layers constituting the encapsulation part 17.

According to an exemplary embodiment, the organic insulating layer may include a protrusion P1 that protrudes toward the light-transmissive area TA. The protrusion P1 may be a portion that protrudes from an upper surface of the opening 11 toward a center C of the light-transmissive area TA, and may be referred to as a first protrusion. Such a protrusion P1 may be formed during laser cutting for forming the light-transmissive area TA.

A coating layer 30 may be disposed on the back surface of the substrate 10 and the opening 11, and may be bonded to the organic insulating layer disposed on the opening 11. The coating layer 30 may be made of an organic material including a polyester-based polymer or an acrylic-based polymer, without being limited thereto.

The coating layer 30 may include a side coating layer 31 formed on an inner side surface of the opening 11 and a back coating layer 32 disposed under the substrate 10, without being limited thereto. Also, the back coating layer 32 may be disposed under the side coating layer 31 and the substrate 10.

A lower surface 3 1a of the side coating layer 31 may be concavely formed toward the anti-etching layer, but is not necessarily limited thereto. For example, the side coating layer 31 shrinks by a certain height and a curvature may be formed on the lower surface 31a of the side coating layer 31. Also, a lower surface of the back coating layer 32 may be concavely formed toward the anti-etching layer, but is not necessarily limited thereto. For example, the side coating layer 31 may not shrink depending on a material. Accordingly, the lower surface 31a of the side coating layer 31 may be substantially flat even after curing is completed.

An inclined surface 11a of the opening 11 and a side surface S11 of the protrusion P1 of the organic insulating layer may have different slopes. Referring to FIG. 3, since the opening 11 is etched by an etching solution to have a tapered shape but the organic insulating layer disposed on the opening 11 is cut by a laser to form a relatively vertical cross-section, an inclination angle of the side surface S11 of the protrusion P1 may be greater than an inclination angle of the inclined surface 11a, without being limited thereto.

A side surface S21 of the coating layer 30 disposed below the protrusion P1 may have the same inclination angle as the side surface S11 of the protrusion P1, but is not necessarily limited thereto. For example, an inclination angle of the side surface S21 of the coating layer 30 disposed below the protrusion P1 may be greater than the inclination angle of the inclined surface 11a, without being limited thereto. For example, the side surface S21 of the coating layer 30 may be formed at the same inclination angle as the inclined surface 11a.

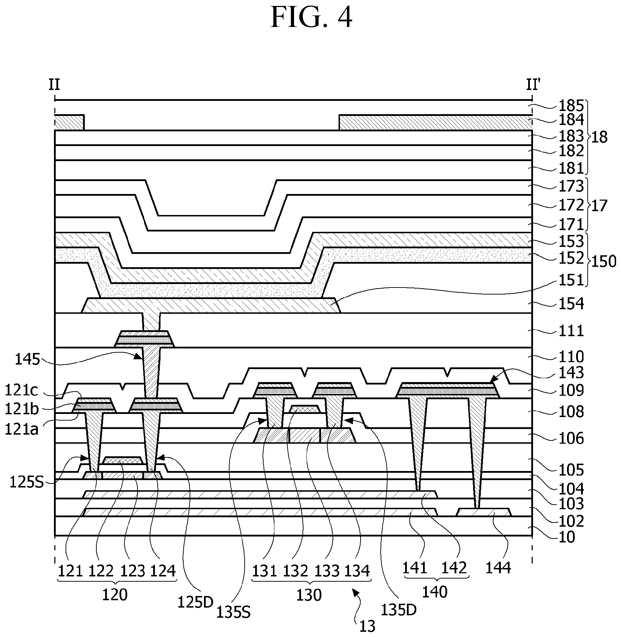

FIG. 4 is a cross-sectional view taken along line II-II' in FIG. 1.

Referring to FIG. 4, a first transistor 120 and a second transistor 130 may be disposed on the substrate 10 in the display area DA, and the light-emitting element 150 may be disposed on a second planarization layer 111. The second planarization layer 111 may be disposed above the first transistor 120 and the second transistor 130.

A storage lower electrode 141 and a metal layer 144 may be disposed on the substrate 10. The storage lower electrode 141 and the metal layer 144 may be disposed on a portion of the substrate 10.

The storage lower electrode 141 may include molybdenum and/or aluminum, without being limited thereto. The storage lower electrode 141 may block light entering a first semiconductor layer 123 or a second semiconductor layer 133. The storage lower electrode 141 may overlap a first semiconductor layer 123 or a second semiconductor layer 133 in the Z direction, and may more effectively block light entering the first semiconductor layer 123 or the second semiconductor layer 133.

The metal layer 144 may be spaced apart from the storage lower electrode 141, and may be formed together with the storage lower electrode 141 in a formation process of the storage lower electrode 141, without being limited thereto.

A multi-buffer layer 102 may be disposed on the storage lower electrode 141, the metal layer 144 and the substrate 10. A multi-buffer layer 102 may delay the diffusion of moisture or oxygen penetrating into the substrate 10, and may be formed by alternately stacking silicon nitride (SiNₓ) and silicon oxide (SiOₓ) at least once.

A storage upper electrode 142 may be disposed on the multi-buffer layer 102. The storage upper electrode 142 may include molybdenum and/or aluminum. The storage upper electrode 142 may block light entering the first semiconductor layer 123 or the second semiconductor layer 133. The storage upper electrode 142 may overlap the storage lower electrode 141 in the Z direction, and may more effectively block light entering the first semiconductor layer 123 or the second semiconductor layer 133. For example, the storage upper electrode 142 may overlap the first semiconductor layer 123 or the second semiconductor layer 133 in the Z direction.

An active buffer layer 103 may perform a function of protecting the first semiconductor layer 123 and blocking various types of defects entering from the substrate 10. The active buffer layer 103 may be made of amorphous silicon (a-Si), silicon nitride (SiNₓ), silicon oxide (SiOₓ), or the like, without being limited thereto.

The first semiconductor layer 123 of the first transistor 120 may be made of a polycrystalline semiconductor layer, and may include a channel region, a source region, and a drain region. The first semiconductor layer 123 may be disposed on the active buffer layer 103.

The polycrystalline semiconductor layer has higher mobility than an amorphous semiconductor layer and an oxide semiconductor layer, resulting in low energy consumption and excellent reliability. Due to these advantages, the polycrystalline semiconductor layer may be used in a driving transistor.

A first gate electrode 122 of the first transistor 120 may be disposed on a lower gate insulating layer 104 and may overlap the first semiconductor layer 123.

The second transistor 130 may be disposed on a lower interlayer dielectric layer 105. The lower interlayer dielectric layer 105 may be disposed on the lower gate insulating layer 104. An upper gate insulating layer 106 may be disposed on the second semiconductor layer 133 to insulate the second gate electrode 132 from the second semiconductor layer 133. For example, the upper gate insulating layer 106 may be disposed between the second gate electrode 132 and the second semiconductor layer 133 to insulate the second gate electrode 132 from the second semiconductor layer 133. Also, the second gate electrode 132 may overlap the second semiconductor layer 133 in the Z-axis direction.

An upper interlayer dielectric layer 108 may be disposed on the second gate electrode 132 of the second transistor 130. The first gate electrode 122 and the second gate electrode 132 may each be a single layer or a multilayer including any one of molybdenum (Mo), aluminum (Al), chromium (Cr), gold (Au), titanium (Ti), nickel (Ni), neodymium (Nd), and copper (Cu), or an alloy thereof, but is not limited thereto.

The lower interlayer dielectric layer 105 may be made of an inorganic insulating layer with a higher hydrogen particle content than the upper interlayer dielectric layer 108, without being limited thereto. For example, the lower interlayer dielectric layer 105 may be made of silicon nitride (SiNₓ) formed through a deposition process using NH₃ gas, and the upper interlayer dielectric layer 108 may be made of silicon oxide (SiOₓ), without being limited thereto. The hydrogen particles included in the lower interlayer dielectric layer 105 may be diffused into the polycrystalline semiconductor layer during a hydrogenation process and may fill voids in the polycrystalline semiconductor layer with hydrogen. Accordingly, the polycrystalline semiconductor layer may be stabilized, thereby preventing deterioration in the characteristics of the first transistor 120.

After the activation and hydrogenation process of the first semiconductor layer 123 of the first transistor 120, the second semiconductor layer 133 of the second transistor 130 may be formed. In such a case, the second semiconductor layer 133 may be made of an oxide semiconductor. Since the second semiconductor layer 133 is not exposed to the high temperature atmosphere of the activation and hydrogenation process of the first semiconductor layer 123, damage to the second semiconductor layer 133 may be prevented and reliability may be improved.

After the upper interlayer dielectric layer 108 is disposed, a first source contact hole 125S and a first drain contact hole 125D may be formed to correspond to source and drain regions of the first transistor 120, respectively, and a second source contact hole 135S and a second drain contact hole 135d may be formed to correspond to source and drain regions of the second transistor 130, respectively.

In the first transistor 120, the first source contact hole 125S and the first drain contact hole 125D may be holes formed continuously from the upper interlayer dielectric layer 108 to the lower gate insulating layer 104 to correspond to source and drain regions of the first transistor 120, respectively. Also in the second transistor 130, the second source contact hole 135S and the second drain contact hole 135D may be holes formed continuously from the upper interlayer dielectric layer 108 to the upper gate insulating layer 106 to correspond to source and drain regions of the second transistor 130, respectively.

A first source electrode 121 and a first drain electrode 124 corresponding to the first transistor 120 and a second source electrode 131 and a second drain electrode 134 corresponding to the second transistor 130 may be formed simultaneously, but is not limited thereto. Through this, the number of processes for forming the source and drain electrodes of each of the first transistor 120 and the second transistor 130 may be reduced.

The first source and drain electrodes 121 and 124 of the first transistor 120 and the second source and drain electrodes 131 and 134 of the second transistor 130 may each be a single layer or a multilayer made of any one of molybdenum (Mo), aluminum (Al), chromium (Cr), gold (Au), titanium (Ti), nickel (Ni), neodymium (Nd), and copper (Cu), or an alloy thereof, but is not limited thereto.

The first source and drain electrodes 121 and 124 and the second source and drain electrodes 131 and 134 may each have a three-layer structure, but is not limited thereto. For example, the first source electrode 121 may include a first electrode layer 121a made of Ti, a second electrode layer 121b made of Al, and a third electrode layer 121c made of Ti, and the other source and drain electrodes may have the same structure.

A storage capacitor 140 may be disposed between the first transistor 120 and the second transistor 130. According to an example embodiment, the storage capacitor 140 may be formed using the storage lower electrode 141 and the storage upper electrode 142. For example, the storage upper electrode 142 may be electrically connected to the pixel circuit through a storage supply line 143. However, the structure of the storage capacitor 140 is not necessarily limited thereto and may be variously modified using two different metal layers.

The storage supply line 143 may be disposed on the upper interlayer dielectric layer 108. The storage supply line 143 may be made of the same material on the same plane as the first source and drain electrodes 121 and 124 and the second source and drain electrodes 131 and 134, without being limited thereto. So that that the storage supply line 143 may be formed simultaneously with the first source and drain electrodes 121 and 124 and the second source and drain electrodes 131 and 134 by using the same mask process.

A protective film 109 may be formed on the entire surface of the substrate 10 on which the first source and drain electrodes 121 and 124, the second source and drain electrodes 131 and 134, and the storage supply line 143 are formed. For example, an inorganic insulating material such as SiNₓ or SiOₓ is deposited on the entire surface of the substrate 10 on which the first source and drain electrodes 121 and 124, the second source and drain electrodes 131 and 134, and the storage supply line 143 are formed, so that the protective film 109 may be formed, but is not limited thereto.

A first planarization layer 110 may be formed on the protective film 109. Specifically, by coating an organic insulating material such as acrylic resin on the entire surface of the protective film 109, the first planarization layer 110 may be disposed, but is not limited thereto.

After the protective film 109 and the first planarization layer 110 are disposed, a contact hole exposing the first source electrode 121 or the first drain electrode 124 of the first transistor 120 may be formed through a photolithography process. A connection electrode 145 may be disposed in the contact hole exposing the first drain electrode 124 by using a material made of Mo, Ti, Cu, AlNd, Al, and Cr, or an alloy thereof, but is not limited thereto. Alternatively, the connection electrode may be disposed in the contact hole exposing the first source electrode 121 by using a material made of Mo, Ti, Cu, AlNd, Al, and Cr, or an alloy thereof.

A second planarization layer 111 may be disposed on the connection electrode 145, and a contact hole exposing the connection electrode 145 may be formed in the second planarization layer 111, so that the light-emitting element 150 connected to the first transistor 120 may be disposed. The connection electrode 145 may be formed with a plurality of layers, like the first source and drain electrodes 121 and 124. For example, the connection electrode 145 may have a three-layer structure, but is not limited thereto.

The light-emitting element 150 may include an anode electrode 151 connected to the first drain electrode 124 of the first transistor 120, at least one emission stack 152 formed on the anode electrode 151, and a cathode electrode 153 formed on the emission stack 152.

The emission stack 152 may include one or more of a hole injection layer, a hole transport layer, an emission layer, an electron transport layer, and an electron injection layer, but is not limited thereto. In a tandem structure in which a plurality of emission layers overlap each other, a charge generation layer may be additionally disposed between the emission layers. The emission layers may emit light of different colors for each subpixel.

The anode electrode 151 may be connected to the connection electrode 145 exposed through the contact hole penetrating the second planarization layer 111. The anode electrode 151 may be formed in a multi-layer structure including a transparent conductive film and an opaque conductive film with high reflection efficiency. The transparent conductive film may be made of a material with a relatively high work function value such as indium-tin-oxide (ITO) or indium-zinc-oxide (IZO), and the opaque conductive film may have a single-layer or multi-layer structure including Al, Ag, Cu, Pb, Mo, Ti, or an alloy thereof, but is not limited thereto.

For example, the anode electrode 151 may be formed in a structure in which a transparent conductive film, an opaque conductive film, and a transparent conductive film are sequentially stacked, or in a structure in which a transparent conductive film and an opaque conductive film are sequentially stacked.

The anode electrode 151 is disposed on the second planarization layer 111 to overlap not only an emission area provided by a bank 154 but also a pixel circuit area where the first and second transistors 120 and 130 and the storage capacitor 140 are disposed, so that an emission area may be increased. The bank 154 serves to define a sub-pixel. Thus, the bank 154 may be made of an insulating material containing a black material. The bank 154 may be made of, for example, a transparent carbon-based mixture. Specifically, the bank 154 may contain carbon black, but is not limited thereto. The bank 154 may also be made of a transparent insulating material.

The emission stack 152 may be formed by stacking a hole transport layer, an organic emission layer, and an electron transport layer on the anode electrode 151 in that order or in the reverse order. In addition, the emission stack 152 may further include a charge generation layer and include first and second emission stacks facing each other with the charge generation layer therebetween. The emission stack 152 may be disposed on the anode electrode 151 and the bank 154.

The bank 154 may be formed to expose the anode electrode 151. Such a bank 154 may be made of an organic material such as photo acryl, and may be a translucent material, but is not limited thereto and may be made of an opaque material in order to prevent light interference between subpixels.

The cathode electrode 153 may be formed on an upper surface of the emission stack 152 to face the anode electrode 151 with the emission stack 152 interposed therebetween. When the cathode electrode 153 is applied to a top-emission organic light-emitting display device, the cathode electrode 153 may be formed by a transparent conductive film in which indium-tin-oxide (ITO), indium-zinc-oxide (IZO), or magnesium-silver (Mg-Ag) is thinly formed, but is not limited thereto.

The encapsulation part 17 may be formed on the cathode electrode 153 of the light-emitting element 150 to protect the light-emitting element 150. Since the light-emitting element 150 may react with external moisture or oxygen due to the organic nature of the emission stack 152 to cause dark-spots or pixel shrinkage, the encapsulation part 17 may be disposed on the cathode electrode 153 in order to prevent such a problem.

The encapsulation part 17 may include a first encapsulation layer 171, a foreign matter compensation layer 172, and a second encapsulation layer 173. The first encapsulation layer 171 and the second encapsulation layer 173 may each be made of an inorganic insulating material and the foreign matter compensation layer 172 may be made of an organic insulating material, but are not necessarily limited thereto. The first encapsulation layer 171 may be disposed on the cathode electrode 153 of the light-emitting element 150, the foreign matter compensation layer 172 may be disposed on the first encapsulation layer 171, and the second encapsulation layer 173 may be disposed on the foreign matter compensation layer 172.

The touch part 18 may be disposed on the encapsulation part 17. The touch part 18 may include a first touch planarization layer 181, a touch buffer layer 182, a touch insulating layer 183, a touch electrode 184, and a second touch planarization layer 185, without being limited thereto. Alternatively, the touch part 18 may include a first touch planarization layer 181, a touch insulating layer 183, a touch electrode 184, and a second touch planarization layer 185.

The first touch planarization layer 181 and the second touch planarization layer 185 may be disposed in order to eliminate a step at the point where the touch electrode 184 is disposed and to ensure good electrical insulation. The first touch planarization layer 181 and the second touch planarization layer 185 may each be made of an organic insulating material such as acrylic-based resin. For example, the first touch planarization layer 181 and the second touch planarization layer 185 may each be made of an organic material such as photo acryl (PAC) or polyimide (PI).

The first touch planarization layer 181 may be disposed on the encapsulation part 17.

The touch buffer layer 182 is disposed on the first touch planarization layer 181. The touch buffer layer 182 may be made of an inorganic material, for example, silicon oxide (SiOx) or silicon nitride (SiNx), but is not limited thereto. For example, when the touch electrode 184 is protected by another insulating layer other than the touch buffer layer 182, the touch buffer layer 182 may not be formed.

The touch insulating layer 183 may be disposed on the touch buffer layer 182. Also, the touch insulating layer 183 may be disposed on the first touch planarization layer 181, and the touch buffer layer 182 may not be formed. The touch insulating layer 183 may be a single layer or a multi-layer made of silicon nitride (SiNx) or silicon oxide (SiOx), without being limited thereto.

The touch electrode 184 may be disposed on the touch insulating layer 183. Specifically, the touch electrode 184 may be disposed on a portion of the touch insulating layer 183 so as to form the step at the point where the touch electrode 184 is disposed.

The second touch planarization layer 185 may be disposed on the touch electrode 184. Specifically, the second touch planarization layer 185 may be disposed on the touch electrode 184 and the portion of the touch insulating layer 183 exposed by the touch electrode 184.

According to embodiments, the first transistor 120 made of low-temperature polycrystalline silicon and the second transistor 130 made of oxide semiconductor may be disposed in different layers, so that a thin film transistor (TFT) having different driving characteristics may be disposed in the display device. However, it is not necessarily limited thereto, and only thin film transistors having the same driving characteristics may be used or thin film transistors having various circuit structures may be used. For example, the first transistor 120 and the second transistor 130 may be disposed in the same layer.

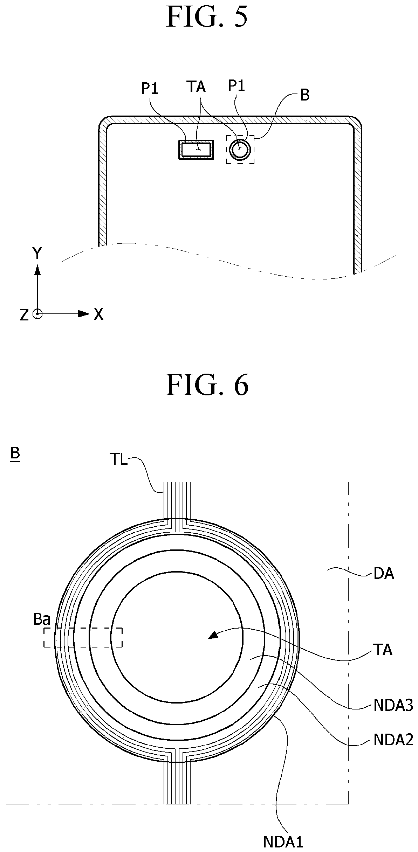

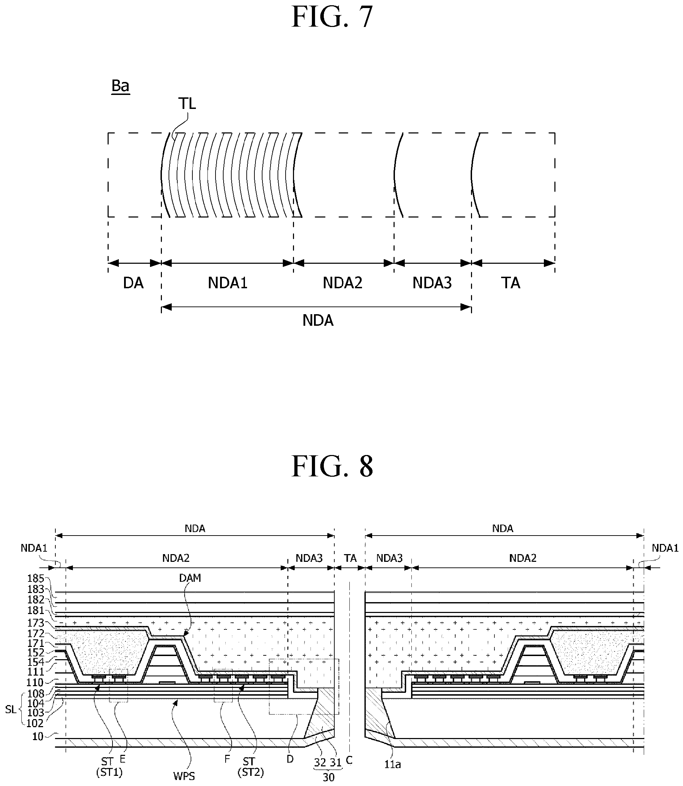

FIG. 5 is a view illustrating the light-transmissive area and a first protrusion surrounding an edge area of the light-transmissive area, FIG. 6 is an enlarged view illustrating an area B in FIG. 5, and FIG. 7 is an enlarged view illustrating an area Ba in FIG. 6.

Referring to FIG. 5, the first protrusion P1 of the organic insulating layer may be disposed to entirely surround the periphery, for example, the edge of the light-transmissive area TA.

When the opening 11 is formed through an etching process, the first protrusion P1 of the organic insulating layer may serve as an anti-etching layer to prevent an etching solution from penetrating into the interior of the display panel 100 during an etching process. Specifically, the first protrusion P1 overlaps the opening 11 in the Z-axis direction and is disposed to cover the upper part of the opening 11, thereby preventing the etching solution from penetrating into the interior of the display panel 100 during an etching process.

Since the display device according to an example embodiment of the present disclosure may form various shapes of openings 11 in the substrate 10 made of glass by using etching, there is an advantage that it is possible to form various openings while maintaining the rigidity of the substrate 10 compared to scribing, breaking, and grinding techniques in the related art.

In addition, the display device according to an example embodiment of the present disclosure has the advantage of enabling process optimization because the opening 11 may be formed along with side processing for forming a notch or rounding on the side surface of the substrate 10. In such a case, it is of course that the organic insulating layer may be formed on the side of the substrate 10.

Referring to FIGS. 6 and 7, the light-transmissive area TA where various sensors are disposed may be formed in a circular shape and the non-display area NDA may be disposed around the light-transmissive area TA, but the present disclosure is not necessarily limited thereto. For example, the light-transmissive area TA may have various shapes such as a polygon or an oval, and the shape of the non-display area NDA may also vary depending on the shape of the light-transmissive area TA.

The non-display area NDA may include a wire area NDA1 where a wire TL that bypasses the light-transmissive area TA is placed, a moisture penetration prevention area NDA2 disposed between the wire area NDA1 and the light-transmissive area TA, and a dummy area NDA3 where the first protrusion P1 is disposed and adjacent to the light-transmissive area TA, without being limited thereto. The dummy area NDA3 may be disposed to surround the light-transmissive area TA. In such a case, the dummy area NDA3 may also play a role in preventing moisture penetration. The moisture penetration prevention area NDA2 may be disposed to surround the dummy area NDA3, and the wire area NDA1 may be disposed to surround the moisture penetration prevention area NDA2.

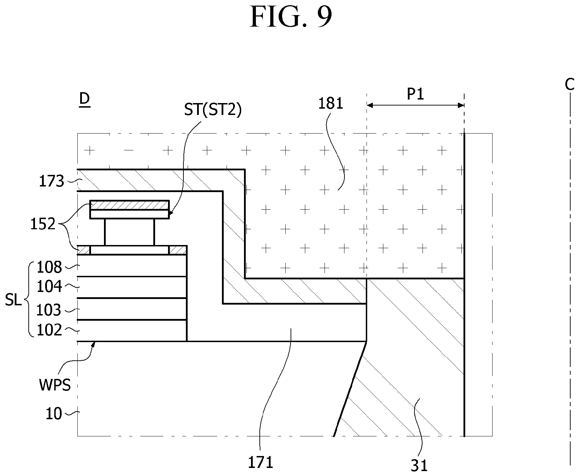

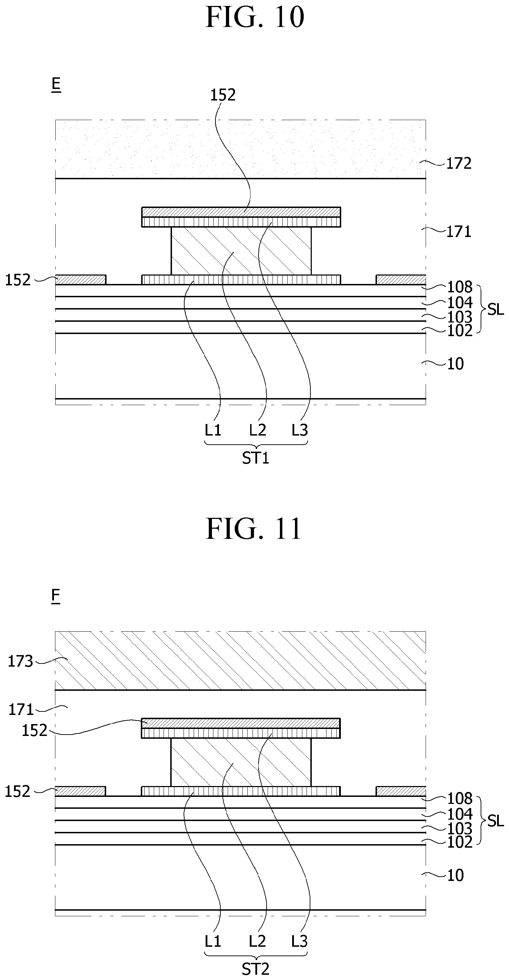

FIG. 8 is a view illustrating an example of a display panel disposed in a display device according to an example embodiment of the present disclosure, FIG. 9 is an enlarged view illustrating an area D in FIG. 8, FIG. 10 is an enlarged view illustrating an area E in FIG. 8, and FIG. 11 is an enlarged view illustrating an area F in FIG. 8. The display panel illustrated in FIG. 8 may represent a display panel according to a first embodiment of the present disclosure.

Referring to 2, 3, 7, and 8, the display panel 100 according to an example embodiment of the present disclosure may include the display area DA, the light-transmissive area TA, and the non-display area NDA surrounding the light-transmissive area TA. The non-display area NDA may include the wire area NDA1, the moisture penetration prevention area NDA2, and the dummy area NDA3. The display panel 100 may include the substrate 10 disposed in the display area DA and the non-display area NDA, the circuit part 13 disposed on the substrate 10, the light-emitting element part 15 disposed on the circuit part 13, the encapsulation part 17 disposed on the light-emitting element part 15, and the touch part 18 disposed on the encapsulation part 17. In such a case, in the non-display area NDA, the substrate 10 and the encapsulation part 17 include the opening 11 disposed corresponding to the light-transmissive area TA, and an organic insulating layer is disposed on the opening 11. The organic insulating layer may be formed by extending the first touch planarization layer 181 among the plurality of layers constituting the touch part 18 toward the light-transmissive area TA, without being limited thereto. Also, the organic insulating layer may be formed by extending the second touch planarization layer 185 among the plurality of layers constituting the touch part 18 toward the light-transmissive area TA.

The wire area NDA1 may be disposed between the display area DA and the moisture penetration prevention area NDA2, and the wire TL that bypasses the light-transmissive area TA may be disposed.

The moisture penetration prevention area NDA2 may be disposed between the wire area NDA1 and the dummy area NDA3. The moisture penetration prevention area NDA2 may have a predetermined length to prevent oxygen, moisture, or the like from entering the interior of the display panel 100 through the light-transmissive area TA. For example, the display device according to an example embodiment of the present disclosure may prevent moisture or oxygen from entering the interior of the display panel 100 by securing a predetermined distance for a movement path of moisture or oxygen through the moisture penetration prevention area NDA2.

The moisture penetration prevention area NDA2 may further have various structures for preventing moisture penetration.

Referring to FIG. 8, the moisture penetration prevention area NDA2 may include a moisture penetration prevention structure WPS for preventing the movement of oxygen, moisture, or the like.

Referring to FIGS. 8 and 9, since the moisture penetration prevention structure WPS is formed on the substrate 10 to have a predetermined height, a step structure may be formed at the boundary between the moisture penetration prevention area NDA2 and the dummy area NDA3. Such a step structure may prevent the penetration of moisture, oxygen, or the like that may enter through the light-transmissive area TA. Since an inorganic insulating layer extending from the encapsulation part 17 of the display area DA toward the light-transmissive area TA covers the side surface of the moisture penetration prevention structure WPS forming the above step structure, the penetration of moisture, oxygen, or the like through the light-transmissive area TA may be prevented more effectively. The inorganic insulating layer disposed to cover the moisture penetration prevention structure WPS may be at least one of the first encapsulation layer 171 and the second encapsulation layer 173 of the encapsulation part 17 extending from the encapsulation part 17 of the display area DA toward the light-transmissive area TA. In other words, the inorganic insulating layer disposed to cover the moisture penetration prevention structure WPS may be a layer extending from at least one of the first encapsulation layer 171 and the second encapsulation layer 173 of the encapsulation part 17. The inorganic insulating layer may be referred to as an inorganic insulating member or an inorganic insulating film.

The moisture penetration prevention structure WPS may include a support layer SL and a plurality of protruding patterns ST disposed on the support layer SL while being spaced apart from each other. The moisture penetration prevention structure WPS may further include a dam DAM disposed on the support layer SL. In addition, the moisture penetration prevention structure WPS may include a light-emitting stack 152 that is not continuously formed by the plurality of protruding patterns ST spaced apart from each other. In addition, the moisture penetration prevention structure WPS may also include an inorganic insulating layer disposed on the plurality of protruding patterns ST where the light-emitting stack 152 is disposed.

In order to implement the step structure at the boundary between the moisture penetration prevention area NDA2 and the dummy area NDA3, the moisture penetration prevention structure WPS may include at least one of the support layer SL, the protruding pattern ST, the dam DAM, the light-emitting stack 152 disposed to be disconnected by the protruding pattern ST, and the inorganic insulating layer disposed on the protruding pattern ST. Such a step structure may prevent the penetration of moisture, oxygen, or the like that may enter through the light-transmissive area TA. In such a case, since the light-emitting stack 152 is disconnected by the plurality of protruding patterns ST disposed to be spaced apart from each other and each having an undercut shape, the light-emitting stack 152 may be additionally disposed on the protruding pattern ST when the protruding pattern ST is a component of the moisture penetration prevention structure WPS. In the display panel according to the first embodiment, the inorganic insulating layer disposed on the plurality of protruding patterns ST extends to the dummy area NDA3 to cover the side surface of the moisture penetration prevention structure WPS, it may be disposed together with other components constituting the moisture penetration prevention structure WPS. For example, in consideration of the fact that the inorganic insulating layer is disposed between the plurality of protruding patterns ST to prevent peeling of the inorganic insulating layer, the inorganic insulating layer may be disposed together with the protruding patterns ST.

The dam DAM and the plurality of protruding patterns ST may be formed using a plurality of layers disposed in the display area DA or a plurality of layers extending from the display area DA, without being limited thereto. In such a case, the number of dams DAM and the number of protruding patterns ST are not particularly limited.

The support layer SL may be disposed on the substrate 10 to have a predetermined height H, and may extend from the display area DA to the boundary between the moisture penetration prevention area NDA2 and the dummy area NDA3, in order to implement the step structure at the boundary between the moisture penetration prevention area NDA2 and the dummy area NDA3. Accordingly, the display device according to an example embodiment of the present disclosure may implement a step structure by using the support layer SL.

The support layer SL may be formed by extending some of a plurality of layers constituting the circuit part 13. For example, the support layer SL may be formed using at least one of a buffer layer and an insulating layer of the circuit part 13, without being limited thereto. As illustrated in FIGS. 8 and 9, the support layer SL may be formed by extending the multi-buffer layer 102, the active buffer layer 103, the lower gate insulating layer 104, and the upper interlayer dielectric layer 108.

The dam DAM and the protruding pattern ST disposed on the support layer SL may be disposed in a closed loop shape surrounding the light-transmissive area TA, thereby preventing moisture or the like from penetrating into the display area DA through the light-transmissive area TA.

The plurality of protruding patterns ST may be disposed on the support layer SL while being spaced apart from each other. In such a case, the protruding pattern ST may include at least one first protruding pattern ST1 disposed on the display area DA side and at least one second protruding pattern ST2 disposed on the light-transmissive area TA side, with respect to the dam DAM, without being limited thereto. Accordingly, the plurality of first protruding patterns ST1 may be disposed between the display area DA and the dam DAM, and the plurality of second protruding patterns ST2 may be disposed between the dam DAM and the dummy area NDA3.

The plurality of protruding patterns ST may include a first pattern layer L1, a second pattern layer L2, and a third pattern layer L3 sequentially stacked. The second pattern layer L2 can be disposed between the first pattern layer L1 and the third pattern layer L3. The first pattern layer L1 and the third pattern layer L3 may each include same material. For example, the first pattern layer L1 and the third pattern layer L3 may each include a titanium (Ti) material, and the second pattern layer L2 may include an aluminum (Al) material, without being limited thereto. As one example, a width of the second pattern layer L2 may be smaller than a width of the third pattern layer L3 and a width of the first pattern layer L1, without being limited thereto.

The protruding pattern ST according to an example embodiment may be made of the same material as the source/drain electrodes 121 and 124 or the connection electrode 145 in the display area DA. For example, the plurality of protruding patterns ST may be formed simultaneously when the connection electrode 145 is formed and then etched to be separated into a plurality of protruding patterns. In such a case, the second pattern layer L2 made of aluminum may be relatively more etched due to the difference in an etching reaction speed. Accordingly, since a width of the second pattern layer L2 may be smaller than a width of the third pattern layer L3, the protruding pattern ST may have an undercut shape. Due to such an undercut shape, the emission stack 152 formed on the plurality of protruding patterns ST may not be continuously formed and may be disconnected between the plurality of protruding patterns ST. Accordingly, the protruding pattern ST may increase a length of a moisture penetration path and simultaneously induce disconnection of the emission stack 152 to block moisture penetration.

The plurality of protruding patterns ST may prevent peeling of the inorganic insulating layer additionally disposed thereon. The inorganic insulating layer may be peeled off relatively easily during laser cutting or external impact. However, according to an example embodiment, since the inorganic insulating layer is filled between the plurality of protruding patterns ST each having an undercut shape, peeling of the inorganic insulating layer may be prevented. Accordingly, the inorganic insulating layer filled between the plurality of protruding patterns ST may more effectively prevent the penetration of moisture. The inorganic insulating layer disposed between the plurality of protruding patterns ST may be formed by extending the first encapsulation layer 171 of the encapsulation part 17 disposed in the display area DA, without being limited thereto. In such a case, a foreign matter compensation layer 172 may be disposed in contact with the first encapsulation layer 171 covering the first protruding pattern ST1, unlike the second protruding pattern ST2. The second encapsulation layer 173 may be disposed in contact with the first encapsulation layer 171 covering the second protruding pattern ST2. The inorganic insulating layer may be disposed to cover the plurality of protruding patterns ST.

The shapes of the plurality of first protruding patterns ST1 and second protruding pattern ST2 may be the same, but are not necessarily limited thereto. The plurality of first protruding patterns ST1 and second protruding pattern ST2 may be variously modified to have a structure capable of disconnecting the light-emitting stack 152. Accordingly, the protruding pattern ST comprising the plurality of first protruding patterns ST1 and second protruding pattern ST2 may increase a length of a moisture penetration path and simultaneously induce disconnection of the emission stack 152 to block moisture penetration.

The dam DAM may be disposed between the plurality of first protruding patterns ST1 and the plurality of second protruding pattern ST2, and may be formed to have a higher height than the protruding pattern ST with respect to the support layer SL. Accordingly, the dam DAM may effectively block oxygen, moisture, or the like entering through the light-transmissive area TA by increasing the length of a path through which oxygen, moisture, or the like penetrates.

The dam DAM may include the same material as the material for forming the first planarization layer 110, the second planarization layer 111, and the bank 154 and may be formed in the same process as the process of forming the first planarization layer 110, the second planarization layer 111, and the bank 154, but is not necessarily limited thereto. For example, the dam DAM may include a metal layer.

The dummy area NDA3 may be an area formed for a margin when the substrate 10 is subjected to etching and/or laser cutting. For example, when there is no dummy area NDA3, the moisture penetration prevention area NDA2 may be damaged during laser cutting, making it vulnerable to moisture penetration, and a minimal layer may be disposed on the substrate 10 in the dummy area NDA3 to facilitate laser cutting. Specifically, laser cutting may be easily performed by disposing the minimum layer extending from the touch part 18 and the opening 11 on the emission line of a laser emitted in order to form the light-transmissive area TA. In such a case, the organic insulating layer disposed on the opening 11 may prevent an etching solution from penetrating into the interior of the display panel 100 when the substrate 10 is etched. The first touch planarization layer 181 extending from the touch part 18 may be provided as an organic insulating layer that is disposed on the opening 11, without being limited thereto. Subsequently, the touch buffer layer 182, the touch insulating layer 183, and the second touch planarization layer 185 may be sequentially disposed on the first touch planarization layer 181.

The opening 11 may be formed in the substrate 10 disposed in the dummy area NAD3 to correspond to the light-transmissive area TA. The opening 11 may have a larger diameter than the light-transmissive area TA.

The side coating layer 31 may be formed on the side surface of the opening 11. The side coating layer 31 may also cover the side surface of the opening 11. The side coating layer 31 may be disposed in the opening 11 to compensate for a step formed in the lower part of the display panel 100 by the opening 11.

Further, the organic insulating layer extending from the touch part 18 may be disposed on the side coating layer 31 and bonded to the side coating layer 31. For example, the first touch planarization layer 181 extending from the touch part 18 may be provided as an organic insulating layer that is disposed on the opening 11, without being limited thereto. Accordingly, even though a laser is emitted in order to form the light-transmissive area TA, layer peeling may be prevented from occurring around the light-transmissive area TA. Since the bonding of the side coating layer 31 and the organic insulating layer may provide the effect of forming a cover made of an organic material around the light-transmissive area TA, moisture, oxygen, or the like may be prevented from penetrating into the interior of the display panel 100 through the light-transmissive area TA.

For example, the display device according to an example embodiment of the present disclosure uses the planarization layer extending from the touch part 18 of the display area DA to the light-transmissive area TA as an organic insulating layer bonded to the side coating layer 31, thereby preventing layer peeling that may occur between a plurality of layers disposed between the substrate 10 and the planarization layer of the touch part 18 and preventing the penetration of moisture, oxygen, or the like through the light-transmissive area TA. Accordingly, the quality and reliability of the display panel 100 may be improved. In addition, since the display device according to an example embodiment of the present disclosure includes the moisture penetration prevention structure WPS formed in a step structure in addition to the planarization layer extending to the light-transmissive area TA and bonding with the side coating layer 31, a wider display area DA may be secured by reducing the horizontal size of the dummy area NDA3.

The side coating layer 31 may be made of an organic material that absorbs light. For example, the side coating layer 31 may include an organic material having an optical density (OD) of 1.0 or more, without being limited thereto.

The back coating layer 32 may be disposed under the substrate 10 and under the side coating layer 31. The back coating layer 32 may extend further from the back surface of the substrate 10 and be formed up to the side coating layer 31. Consequently, the back coating layer 32 may be prevented from being peeled off from the substrate 10.

The display device according to an example embodiment of the present disclosure may improve the adhesion of the back coating layer 32 by forming the back coating layer 32 to cover the side coating layer 31. In a case where the back coating layer 32 may be formed only on the back surface of the substrate 10 in order to protect the substrate 10, the back coating layer 32 may be peeled off from the substrate 10 due to external environment or impact. However, since the back coating layer 32 made of an organic material has a relatively low adhesion with the substrate 10, it may be peeled off from the substrate 10 due to external environment or impact. Accordingly, the adhesion of the back coating layer 32 may be improved by bonding the back coating layer 32 to the side coating layer 31 made of an organic material at the opening 11 of the substrate 10. Consequently, the back coating layer 32 may be prevented from being peeled off from the substrate 10.

According to an example embodiment, the side surface of the light-transmissive area TA may be formed vertically, without being limited thereto. For example, the side surface of the back coating layer 32, the side surface of the side coating layer 31, the side surface of the protective layer PL, and the side surface of the polarizing plate 19, which form the side surface of the light-transmissive area TA, may be cut with a laser to have the same vertical plane.

In addition, an inorganic insulating layer may be disposed in contact with the upper surface of the substrate 10 disposed in the dummy area NDA3. The inorganic insulating layer may cover the side surface of the moisture penetration prevention structure WPS and then extend to the upper surface of the substrate 10. Accordingly, the inorganic insulating layer covers a gap between various layers constituting the moisture penetration prevention structure WPS, thereby preventing oxygen, moisture, or the like from entering the interior of the display panel 100 through the gaps.

The inorganic insulating layer may be formed by extending at least one of the first encapsulation layer 171 and the second encapsulation layer 173 of the encapsulation part 17. As illustrated in FIGS. 8 and 9, the inorganic insulating layer may be formed of two layers formed by extending the first encapsulation layer 171 and the second encapsulation layer 173 of the encapsulation part 17, without being limited thereto. Alternatively, the inorganic insulating layer may be formed of only one of the first encapsulation layer 171 and the second encapsulation layer 173 of the encapsulation part 17.

Since the inorganic insulating layer disposed in the dummy area NDA3 may be etched together with the substrate 10 when the opening 11 is formed by an etching process, the end portion of the inorganic insulating layer may be exposed by the opening 11. Accordingly, the end portion of the inorganic insulating layer may be configured to form the opening 11 together with the inclined surface 11a formed on the substrate 10, and may be in contact with the side coating layer 31. The end portion of the inorganic insulating layer may be spaced apart from a laser emission line by an etching process. The laser may be used in a laser cutting process for forming the light-transmissive area TA. Accordingly, since the inorganic insulating layer is relatively distant from the organic insulating layer disposed on the laser emission line, damage caused by the laser may be reduced.

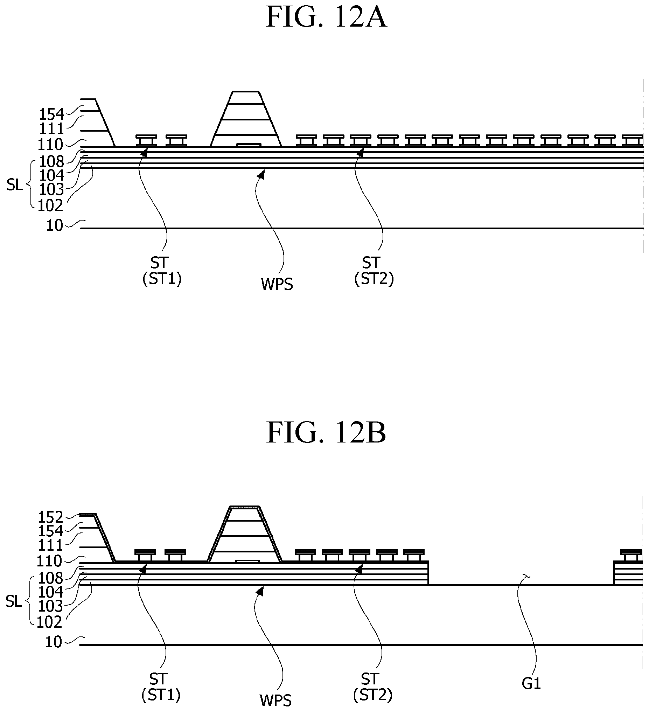

FIGS. 12A to 12H are views illustrating a process of forming a light-transmissive area in the display panel according to the first embodiment of the present disclosure.

FIG. 12A is a view illustrating a step of forming a support layer and a protruding pattern and a dam disposed on the support layer.

Referring to FIG. 12A, the support layer SL may be formed on the substrate 10, and the dam DAM and the plurality of protruding patterns ST may be formed on the support layer SL. The dam DAM may be disposed between the plurality of first protruding patterns ST1 and the plurality of second protruding pattern ST2. The support layer SL may be formed by extending the multi-buffer layer 102, the active buffer layer 103, the lower gate insulating layer 104, the upper interlayer dielectric layer 108, and the like disposed in the display area DA, without being limited thereto.

The protruding pattern ST may be formed when the source and drain electrodes 121 and 124 or the connection electrode 145 of the display area DA is formed. In such a case, the protruding pattern ST may be formed into an undercut shape such as an 'I' shape through an etching process.

The dam DAM may be formed when at least one of the first planarization layer 110, the second planarization layer 111, and the bank 154 disposed in the display area DA is formed. In such a case, the dam DAM may be formed to have a higher height than the protruding pattern ST with respect to the support layer SL. Accordingly, the dam DAM may effectively block oxygen, moisture, or the like entering through the light-transmissive area TA by increasing the length of a path through which oxygen, moisture, or the like penetrates.

FIG. 12B is a view illustrating a step of forming a groove corresponding to a dummy area after a light-emitting stack is stacked.

Referring to FIG. 12B, the light-emitting stack 152 may be stacked on the protruding pattern ST having an undercut shape. Accordingly, the light-emitting stack 152 formed on the plurality of protruding patterns ST may not be continuously formed and may be disconnected between the plurality of protruding patterns ST. Accordingly, the protruding pattern ST may increase a length of a moisture penetration path and simultaneously induce disconnection of the emission stack 152 to block moisture penetration.

Subsequently, a groove G1 corresponding to the dummy area NDA3 may be formed using a laser or the like. The groove G1 may be referred to as a first groove.

The groove G1 may be formed in a closed loop shape, and as the groove G1 is formed, a step structure may be formed at the boundary between the moisture penetration prevention area NDA2 and the dummy area NDA3.

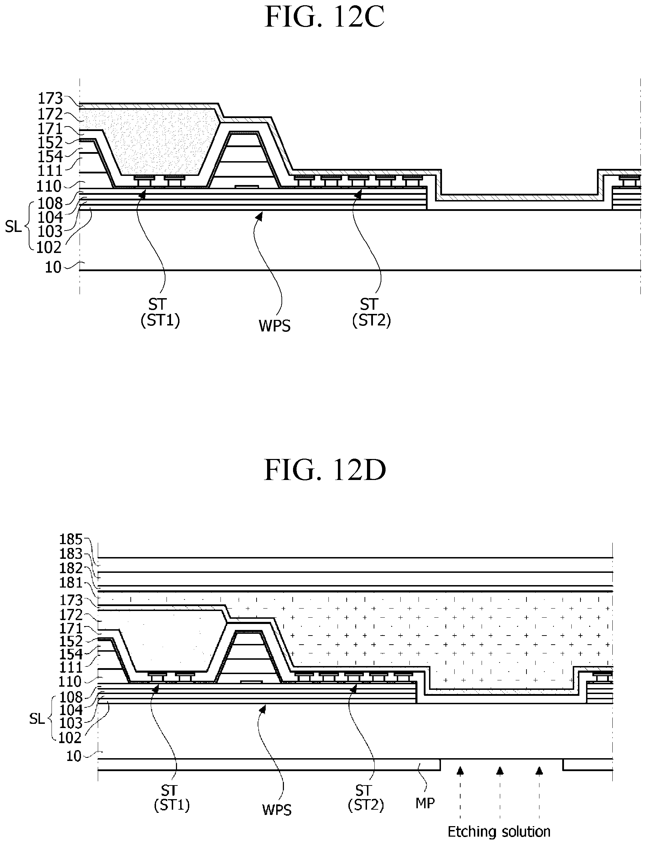

FIG. 12C is a view illustrating a step of forming an inorganic insulating layer.

Referring to FIG. 12C, the inorganic insulating layer extending from the encapsulation part 17 of the display area DA toward the light-transmissive area TA may be disposed on the light-emitting stack 152. In such a case, the inorganic insulating layer may be disposed between the plurality of protruding patterns ST and in the groove G1. The inorganic insulating layer may be a layer made of an inorganic insulating material formed by extending the first encapsulation layer 171 and the second encapsulation layer 173 of the encapsulation part 17. The foreign matter compensation layer 172 may be disposed in contact with the first encapsulation layer 171 covering the first protruding pattern ST1, and the second encapsulation layer 173 may be disposed in contact with the first encapsulation layer 171 covering the second protruding pattern ST2, without being limited thereto. In such a case, the inorganic insulating layer may be formed of only one of the first encapsulation layer 171 and the second encapsulation layer 173.

FIG. 12D is a view illustrating a step of forming an organic insulating layer and disposing a mask pattern on the back surface of the substrate.

Referring to FIG. 12D, the organic insulating layer may be disposed on the inorganic insulating layer illustrated in FIG. 12C. The organic insulating layer may be formed by extending at least one of the layers constituting the touch part 18. As illustrated in FIG. 12D, the first touch planarization layer 181 may be disposed on the inorganic insulating layer and may serve as an organic insulating layer, without being limited thereto. Subsequently, the touch buffer layer 182, the touch insulating layer 183, and the second touch planarization layer 185 may be sequentially disposed on the first touch planarization layer 181.

In addition, a mask pattern MP may be formed under the substrate 10. According to an example embodiment, the mask pattern MP may be formed according to the number and shape of openings to be formed in the substrate 10 and exposed to an etching solution to simultaneously form a plurality of openings. In such a case, the formation of the opening using the etching process and separation of the mother substrate into panels may be performed at the same time.

The example embodiment describes an example in which an etching process is performed using the mask pattern MP, but is not necessarily limited thereto. For example, without placing the mask pattern MP on the back surface of the substrate 10, the etching process may be performed after emitting a laser at a position where the opening 11 is expected to be formed. Accordingly, one area of the substrate 10 irradiated with the laser may react more to an etching solution than another area to form the opening 11.

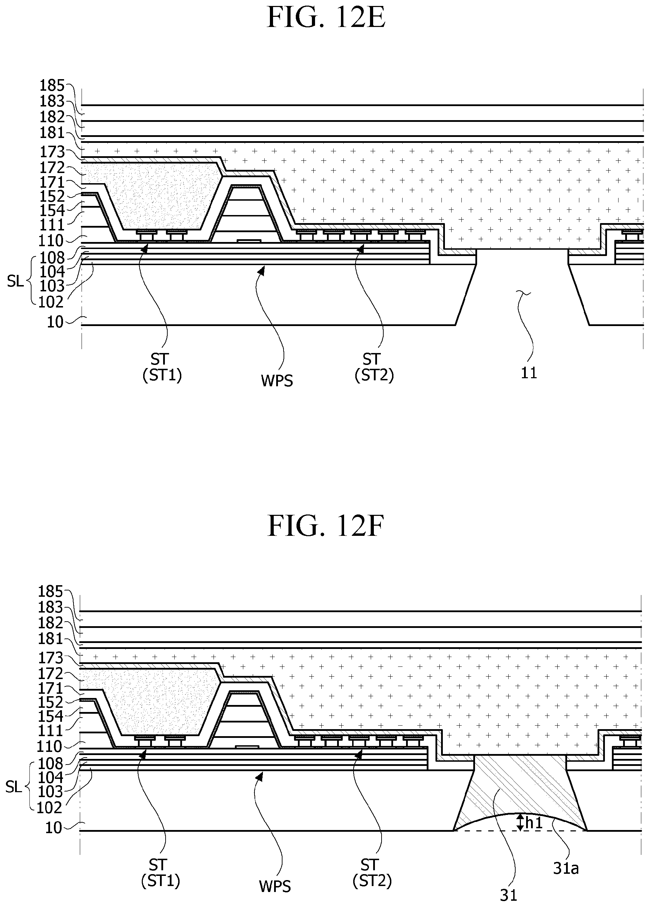

FIG. 12E is a view illustrating a step of forming an opening on the back surface of the substrate through an etching process.

Referring to FIG. 12E, when an etching solution is brought into contact with an exposed area of the substrate 10, a partial area of the back surface of the substrate 10 exposed between the mask patterns MP may be etched to form the opening 11. In such a case, a part of the inorganic insulating layer formed on the etched substrate 10 may be etched together with the substrate 10 to form the opening 11. Accordingly, an end portion of the inorganic insulating layer disposed in the dummy area NDA3 may be exposed by the opening 11. The substrate 10 and the encapsulation part 17 may surround the opening 11 disposed corresponding to the light-transmissive area TA.

Subsequently, the first touch planarization layer 181 disposed on the inorganic insulating layer and serving as an organic insulating layer may prevent the etching solution from penetrating into the interior of the display panel 100. The organic insulating layer disposed on the opening 11 may be formed together with when the first touch planarization layer 181 of the display area DA is formed, thereby implementing process optimization.

FIG. 12F is a view illustrating a step of disposing a side coating layer in the opening.

Referring to FIG. 12F, the opening 11 of the substrate 10 may be filled with the side coating layer 31. Subsequently, when the side coating layer 31 is cured, the side coating layer 31 shrinks by a certain height h1 and a curvature may be formed on the lower surface 31a of the side coating layer 31. However, the side coating layer 31 may not shrink depending on a material. For example, the lower surface 31a of the side coating layer 31 may be substantially flat even after curing is completed.

In addition, the side coating layer 31 may be cured and bonded to the first touch planarization layer 181 serving as an organic insulating layer. Also, the side coating layer 31 may be bonded to the end portion of the inorganic insulating layer extending exposed to the opening 11. Accordingly, the bonding may prevent layer peeling from occurring around the light-transmissive area TA and prevent moisture, oxygen, or the like from penetrating into the interior of the display panel 100 through the light-transmissive area TA.

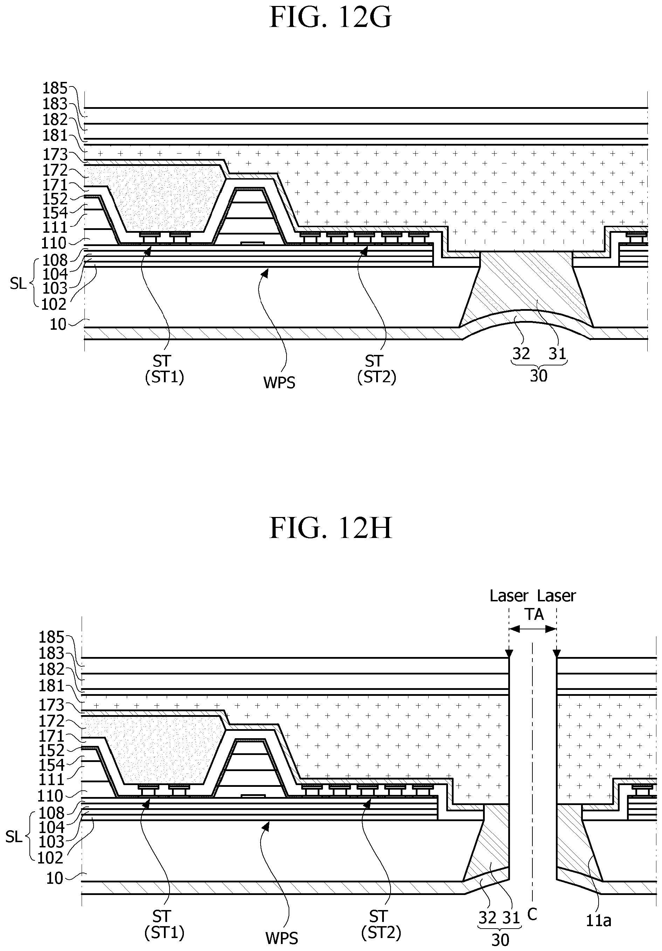

FIG. 12G is a view illustrating a step of disposing a back coating layer.

Referring to FIG. 12G, the back coating layer 32 may be entirely formed on the back surface as the lower surface of the substrate 10 and the back surface of the side coating layer 31. However, the present disclosure is not necessarily limited thereto, and the back coating layer 32 may be formed only on the lower surface of the substrate 10. Specifically, a lower surface of the back coating layer 32 may be concavely formed toward the anti-etching layer, but is not necessarily limited thereto.

FIG. 12H is a view illustrating a laser cutting step.

Referring to FIG. 12H, the light-transmissive area TA may be formed by irradiating the opening 11 side of the substrate 10 with a laser. In such a case, the organic insulating layer, the side coating layer 31, or the like may be cut by a laser. Since the display device according to an example embodiment of the present disclosure includes bonding of the side coating layer 31 and the organic insulating layer and an end portion of the inorganic insulating layer disposed farther from the light-transmissive area TA than the organic insulating layer by an etching process, even though the laser for the light-transmissive area TA is emitted, peeling of the inorganic insulating layer due to laser emission may be prevented.

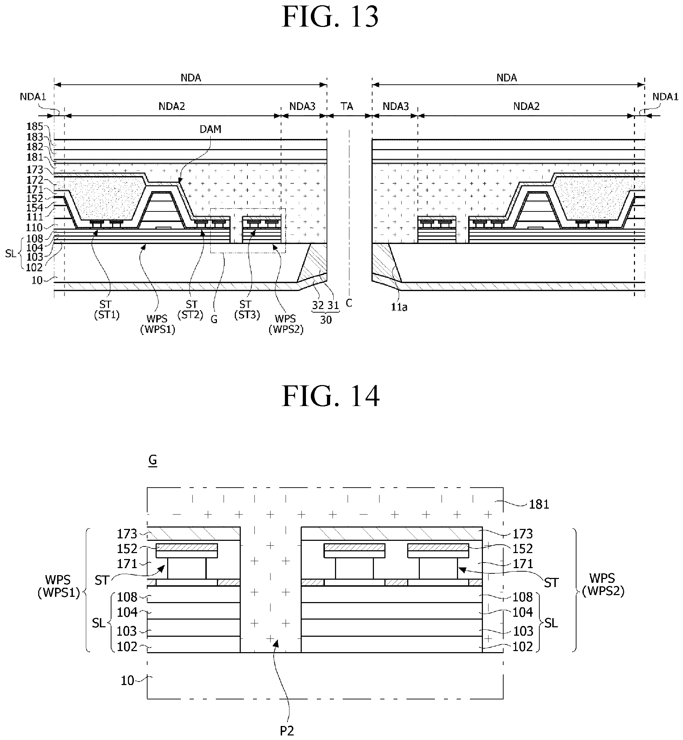

FIG. 13 is a view illustrating another example of a display panel disposed in a display device according to an example embodiment of the present disclosure, and FIG. 14 is an enlarged view illustrating an area G in FIG. 13. The display panel illustrated in FIG. 13 may represent a display panel according to a second embodiment of the present disclosure.

When the display panel according to the first embodiment is compared with the display panel according to the second embodiment with reference to FIGS. 8 and 13, the display panel according to the second embodiment is different from the display panel according to the first embodiment in that a part of the organic insulating layer in the moisture penetration prevention area NDA2 is disposed in contact with the upper surface of the substrate 10 to separate the moisture penetration prevention structure WPS, no inorganic insulating layer is disposed in the dummy area NDA3, and the like. Accordingly, the display panel according to the second embodiment may further reduce the horizontal length of the dummy area NDA3 compared to the display panel according to the first embodiment.

In describing the display panel according to the second embodiment, the same components as those of the display panel according to the first embodiment may be denoted by the same reference numerals, and therefore detailed description thereof will be omitted or briefly given.

Referring to FIGS. 2, 3, 7, and 13, the display panel 100 according to an example embodiment of the present disclosure may include the display area DA, the light-transmissive area TA, and the non-display area NDA surrounding the light-transmissive area TA. The non-display area NDA may include the wire area NDA1, the moisture penetration prevention area NDA2, and the dummy area NDA3. The display panel 100 may include the substrate 10 disposed in the display area DA and the non-display area NDA, the circuit part 13 disposed on the substrate 10, the light-emitting element part 15 disposed on the circuit part 13, the encapsulation part 17 disposed on the light-emitting element part 15, and the touch part 18 disposed on the encapsulation part 17. In such a case, in the non-display area NDA, the substrate 10 and the encapsulation part 17 include the opening 11 disposed corresponding to the light-transmissive area TA, and an organic insulating layer is disposed between two moisture penetration prevention structures WPS separated from an upper part of the opening 11. The organic insulating layer may be formed by extending the first touch planarization layer 181 among the plurality of layers constituting the touch part 18 toward the light-transmissive area TA, without being limited thereto. Subsequently, the touch buffer layer 182, the touch insulating layer 183, and the second touch planarization layer 185 may be sequentially disposed on the first touch planarization layer 181.

Referring to FIG. 13, the moisture penetration prevention area NDA2 may have various structures for preventing moisture penetration, and the display panel according to the second embodiment may more effectively respond to moisture penetration by using two moisture penetration prevention structures WPS spaced apart from each other and an organic insulating layer disposed between the two moisture penetration prevention structures WPS.

Referring to FIGS. 13 and 14, the moisture penetration prevention structure WPS disposed on the display panel according to the second embodiment is formed on the substrate 10 to have a predetermined height, and includes a first moisture penetration prevention structure WPS1 and a second moisture penetration prevention structure WPS2 spaced apart from each other. However, the present disclosure is not limited thereto, and the moisture penetration prevention structure WPS may be formed as two or more structures spaced apart from each other. In addition, the first moisture penetration prevention structure WPS1 and the second moisture penetration prevention structure WPS2 separated into two may be formed to have the same height and the same buffer layer, insulating layer, metal layer, or the like, but are not necessarily limited thereto.

The first moisture penetration prevention structure WPS1 and the second moisture penetration prevention structure WPS2 may each include the support layer SL and the plurality of protruding patterns ST disposed to be spaced apart from each other on the support layer SL. In addition, the first moisture penetration prevention structure WPS1 and the second moisture penetration prevention structure WPS2 may each include the light-emitting stack 152 that is not continuously formed by the plurality of protruding patterns ST disposed to be spaced apart from each other. In addition, the first moisture penetration prevention structure WPS1 and the second moisture penetration prevention structure WPS2 may each include an inorganic insulating layer disposed on the plurality of protruding patterns ST where the light-emitting stack 152 is disposed.

The first moisture penetration prevention structure WPS1 may further include the dam DAM disposed on the support layer SL. The plurality of protruding patterns ST may be disposed on the support layer SL while being spaced apart from each other. In such a case, the protruding pattern ST disposed on the first moisture penetration prevention structure WPS 1 may include the plurality of first protruding patterns ST1 disposed on the display area DA side and the plurality of second protruding patterns ST2 disposed on the light-transmissive area TA side with respect to the dam DAM. Accordingly, the plurality of first protruding patterns ST1 may be disposed between the display area DA and the dam DAM, and the plurality of second protruding patterns ST2 may be disposed between the dam DAM and the dummy area NDA3. For example, the dam DAM may be disposed between the plurality of first protruding patterns ST1 and the plurality of second protruding patterns ST2.

The second moisture penetration prevention structure WPS2 may be disposed between the first moisture penetration prevention structure WPS1 and the dummy area NDA3, and may be disposed in the moisture penetration prevention area NDA2 to be spaced apart from the first moisture penetration prevention structure WPS1.

The second moisture penetration prevention structure WPS2 having a predetermined height on the substrate 10 may form a step structure at the boundary between the moisture penetration prevention area NDA2 and the dummy area NDA3. Such a step structure may prevent the penetration of moisture, oxygen, or the like that may enter through the light-transmissive area TA.

In addition, the second moisture penetration prevention structure WPS2 may include a plurality of protruding patterns ST, and the protruding pattern ST disposed on the second moisture penetration prevention structure WPS2 may be referred to as a third protruding pattern ST3. Accordingly, the plurality of protruding patterns ST may include the first protruding pattern ST1 and the second protruding pattern ST2 disposed on the first moisture penetration prevention structure WPS1 with the dam DAM interposed therebetween, and the third protruding pattern ST3 separated from the first protruding pattern ST1 and the second protruding pattern ST2 by an organic insulating layer disposed between the two moisture penetration prevention structures WPS1 and WPS2. The third protruding pattern ST3 may have the same shape as the plurality of first protruding patterns ST1 and the plurality of second protruding patterns ST2, but is not necessarily limited thereto. For example, the first protruding pattern ST1 and the second protruding pattern ST2 may have the same shape, but since the third protruding pattern ST3 is disposed adjacent to the light-transmissive area TA, the third protruding pattern ST3 may be formed to have a different shape from the first protruding pattern ST1. The plurality of first protruding patterns ST1, the plurality of second protruding patterns ST2, and the plurality of third protruding patterns ST3 may be variously modified to have a structure capable of disconnecting the light-emitting stack 152. The third protruding patterns ST3 may be disposed between the plurality of second protruding patterns ST2 and the dummy area NDA3.

The display panel according to the second embodiment may include an organic insulating layer disposed between the first moisture penetration prevention structure WPS1 and the second moisture penetration prevention structure WPS2, and the organic insulating layer may be formed by extending downward the first touch planarization layer 181 of the touch part 18 extending toward the light-transmissive area TA. Specifically, the first touch planarization layer 181 of the touch part 18 may extend downward between the first moisture penetration prevention structure WPS1 and the second moisture penetration prevention structure WPS2. Accordingly, the organic insulating layer disposed between the first moisture penetration prevention structure WPS1 and the second moisture penetration prevention structure WPS2 may be referred to as a protrusion, and may be referred to as a second protrusion P2 to be distinguished from the first protrusion P1.

The display panel according to the second embodiment may improve the moisture penetration prevention effect by disposing the second protrusion P2 of the organic insulating layer between the first moisture penetration prevention structure WPS 1 and the second moisture penetration prevention structure WPS2 spaced apart from each other.

For example, the display panel according to the second embodiment may form a structure that is more resistant to moisture penetration by disposing the organic insulating layer between the two moisture penetration prevention structures WPS1 and WPS2. Accordingly, since the inorganic insulating layer disposed on the substrate 10 in the dummy area while covering the side surface of the moisture penetration prevention structure WPS in the display panel according to the first embodiment may be removed from the display panel according to the second embodiment, the horizontal length of the dummy area NDA3 in the display panel according to the second embodiment may be reduced compared to the display panel according to the first embodiment.

The dummy area NDA3 may be an area formed for a margin when the substrate 10 is subjected to etching and/or laser cutting. However, when there is no dummy area NDA3, the moisture penetration prevention area NDA2 may be damaged during laser cutting, making it vulnerable to moisture penetration. For example, laser cutting may be easily performed by disposing a minimum layer extending from the touch part 18 and the opening 11 on the emission line of a laser emitted in order to form the light-transmissive area TA. In such a case, the organic insulating layer disposed on the opening 11 may prevent an etching solution from penetrating into the interior of the display panel 100 when the substrate 10 is etched. Here, the first touch planarization layer 181 extending from the touch part 18 may be provided as an organic insulating layer disposed on the opening 11.

The opening 11 may be formed in the substrate 10 disposed in the dummy area NAD3 to correspond to the light-transmissive area TA, and the side coating layer 31 may be formed in the opening 11. Subsequently, the organic insulating layer extending from the touch part 18 may be disposed on the side coating layer 31 and bonded to the side coating layer 31. Subsequently, the back coating layer 32 may be disposed under the substrate 10 and under the side coating layer 31, without being limited thereto. However, the present disclosure is not necessarily limited thereto, and the back coating layer 32 may be formed only on the lower surface of the substrate 10. Specifically, the lower surfaces of the side coating layer 31 and the back coating layer 32 may be concavely formed toward the anti-etching layer, but is not necessarily limited thereto.

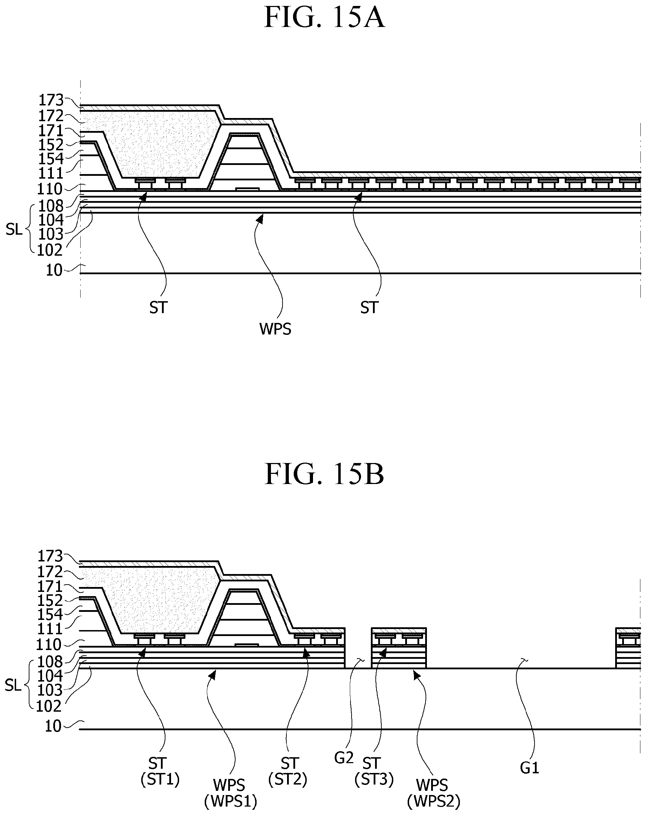

FIGS. 15A to 15H are views illustrating a process of forming a light-transmissive area in the display panel according to the second embodiment of the present disclosure.

FIG. 15A is a diagram illustrating a step of forming a support layer, a protruding pattern and a dam disposed on the support layer, a light-emitting stack disposed on the protruding pattern and the dam, and an inorganic insulating layer disposed on the light-emitting stack.

Referring to FIG. 15A, the support layer SL may be formed on the substrate 10, and the dam DAM and the plurality of protruding patterns ST may be formed on the support layer SL. Subsequently, the light-emitting stack 152 may be formed on the protruding pattern ST having an undercut shape. Accordingly, the light-emitting stack 152 may not be continuously formed and may be disconnected between the plurality of protruding patterns ST. Subsequently, an inorganic insulating layer may be formed on the dam DAM and the plurality of protruding patterns ST on which the light-emitting stack 152 is disposed. The inorganic insulating layer may be a layer made of an inorganic insulating material formed by extending the first encapsulation layer 171 and the second encapsulation layer 173 of the encapsulation part 17. In such a case, the inorganic insulating layer may be formed of only one of the first encapsulation layer 171 and the second encapsulation layer 173.

FIG. 15B is a view illustrating a step of forming a groove corresponding to the dummy area and a groove separating the moisture penetration prevention structure.

Referring to FIG. 15B, a groove G1 corresponding to the dummy area NDA3 and a groove G2 separating the moisture penetration prevention structure WPS into the first moisture penetration prevention structure WPS1 and the second moisture penetration prevention structure WPS2 may be formed using a laser or the like. The groove G1 corresponding to the dummy area NDA3 may be referred to as a first groove, and the groove G2 separating the moisture penetration prevention structure WPS into the first moisture penetration prevention structure WPS1 and the second moisture penetration prevention structure WPS2 may be referred to as a second groove.

The first groove G1 and the second groove G2 may each be formed in a closed loop shape, and as the first groove G1 is formed, a step structure may be formed at the boundary between the moisture penetration prevention area NDA2 and the dummy area NDA3. Such a step structure may prevent the penetration of moisture, oxygen, or the like that may enter through the light-transmissive area TA. As the second groove G2 is formed, the moisture penetration prevention structure WPS may be separated into two. In such a case, the second moisture penetration prevention structure WPS2 may include the support layer SL, the third protruding pattern ST3 disposed on the support layer SL, the light-emitting stack 152 disposed to be disconnected by the third protruding pattern ST3, and an inorganic insulating layer disposed on the third protruding pattern ST3 where the light-emitting stack 152 is disposed.

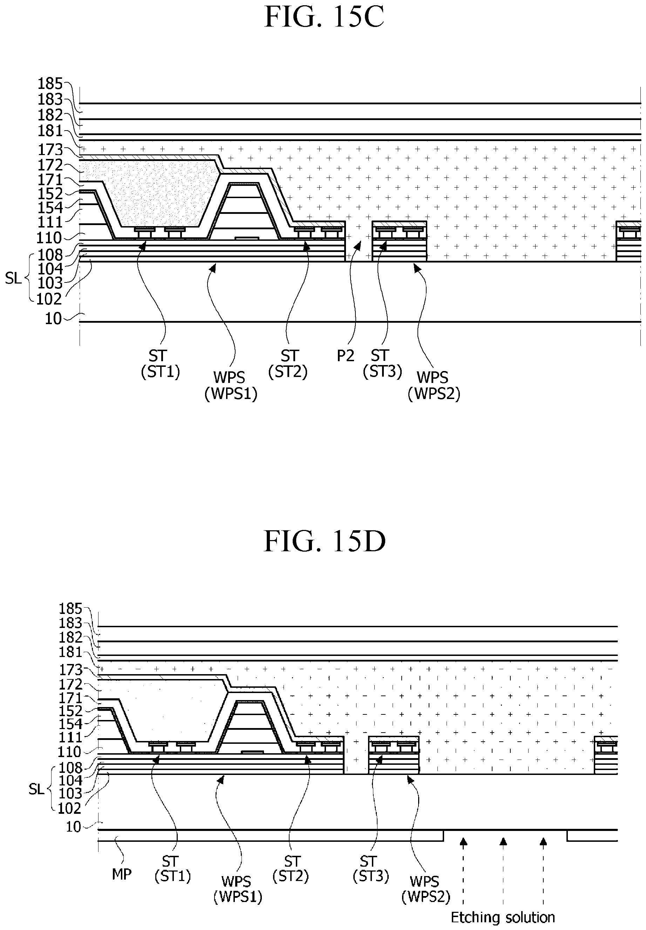

FIG. 15C is a view illustrating a step of forming an organic insulating layer in the first groove and the second groove.

Referring to FIG. 15C, the organic insulating layer may be disposed in the first groove G1 and the second groove G2. In such a case, the organic insulating layer may be on the inorganic insulating layer. The organic insulating layer may be formed by extending at least one of the layers constituting the touch part 18. For example, when the first touch planarization layer 181 extending from the display area DA is disposed on the inorganic insulating layer, a part of the first touch planarization layer 181 extending from the display area DA may also be disposed in the first groove G1 and the second groove G2. The part of the first touch planarization layer 181 disposed in the second groove G2 may be referred to as the second protrusion P2. The organic insulating layer may be formed by extending the first touch planarization layer 181 among the plurality of layers constituting the touch part 18 toward the light-transmissive area TA, without being limited thereto.

Subsequently, the touch buffer layer 182, the touch insulating layer 183, and the second touch planarization layer 185 may be sequentially disposed on the first touch planarization layer 181.

FIG. 15D is a view illustrating a step of disposing a mask pattern on the back surface of the substrate.

Referring to FIG. 15D, the mask pattern MP may be formed under the substrate 10. According to an example embodiment, the mask pattern MP may be formed according to the number and shape of openings to be formed in the substrate 10 and exposed to an etching solution to simultaneously form a plurality of openings. The example embodiment describes an example in which an etching process is performed using the mask pattern MP, but is not necessarily limited thereto. For example, without placing the mask pattern MP on the back surface of the substrate 10, the etching process may be performed after emitting a laser at a position where the opening 11 is expected to be formed. Accordingly, one area of the substrate 10 irradiated with the laser may react more to an etching solution than another area to form the opening 11.

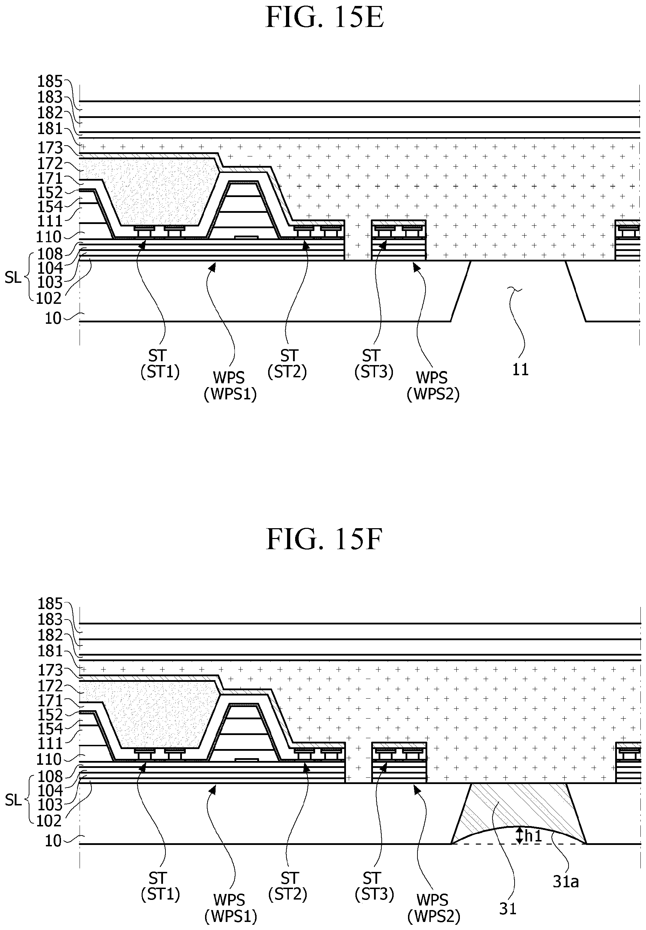

FIG. 15E is a view illustrating a step of forming an opening on the back surface of the substrate through an etching process.

Referring to FIG. 15E, when an etching solution is brought into contact with an exposed area of the substrate 10, a partial area of the back surface of the substrate 10 exposed between the mask patterns MP may be etched to form the opening 11. The substrate 10 may surround the opening 11.

Subsequently, the first touch planarization layer 181 disposed on the opening 11 and serving as an organic insulating layer may prevent the etching solution from penetrating into the interior of the display panel 100. The organic insulating layer disposed on the opening 11 may be formed together when the first touch planarization layer 181 of the display area DA is formed, thereby implementing process optimization.

FIG. 15F is a view illustrating a step of disposing a side coating layer in the opening.

Referring to FIG. 15F, the opening 11 of the substrate 10 may be filled with the side coating layer 31. Subsequently, when the side coating layer 31 is cured, the side coating layer 31 may shrink by a certain height h1 and a curvature may be formed on the lower surface 31a of the side coating layer 31. However, the side coating layer 31 may not shrink depending on a material. For example, the lower surface 31a of the side coating layer 31 may be substantially flat even after curing is completed.

In addition, the side coating layer 31 may be cured and bonded to the first touch planarization layer 181 serving as an organic insulating layer. Accordingly, the bonding may prevent layer peeling from occurring around the light-transmissive area TA and prevent moisture, oxygen, or the like from penetrating into the interior of the display panel 100 through the light-transmissive area TA.

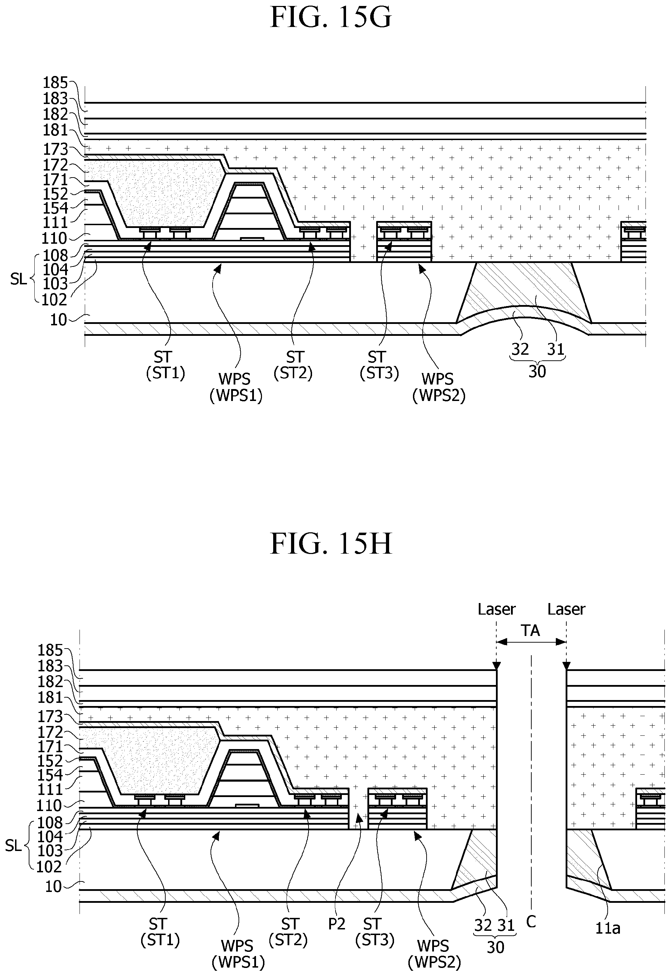

FIG. 15G is a view illustrating a step of disposing a back coating layer.

Referring to FIG. 15G, the back coating layer 32 may be entirely formed on the back surface as the lower surface of the substrate 10 and the back surface of the side coating layer 31. Specifically, a lower surface of the back coating layer 32 may be concavely formed toward the anti-etching layer, but is not necessarily limited thereto. However, the present disclosure is not necessarily limited thereto, and the back coating layer 32 may be formed only on the lower surface of the substrate 10.

FIG. 15H is a view illustrating a laser cutting step.

Referring to FIG. 15H, the light-transmissive area TA may be formed by irradiating the opening 11 side of the substrate 10 with a laser. In such a case, the organic insulating layer, the side coating layer 31, or the like may be cut by a laser. Since the display device according to an example embodiment of the present disclosure includes bonding of the side coating layer 31 and the organic insulating layer and an inorganic insulating layer that is not disposed in the dummy area NDA3, even though the laser for the light-transmissive area TA is emitted, peeling of the inorganic insulating layer due to laser irradiation may be prevented.

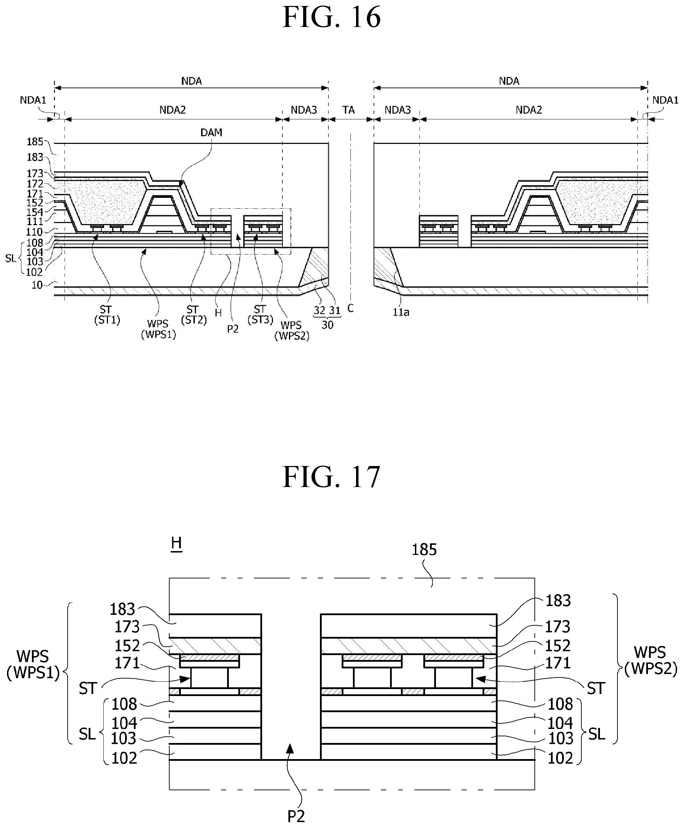

FIG. 16 is a view illustrating further another example of a display panel disposed in a display device according to an example embodiment of the present disclosure, and FIG. 17 is an enlarged view illustrating an area H in FIG. 16. The display panel illustrated in FIG. 16 may represent a display panel according to a third embodiment of the present disclosure.

When the display panel according to the second embodiment is compared with the display panel according to the third embodiment with reference to FIGS. 13 and 16, the display panel according to the third embodiment is different from the display panel according to the second embodiment in that a part of the second touch planarization layer 185 provided as an organic insulating layer in the moisture penetration prevention area NDA2 is extended toward the substrate 10 to be disposed in contact with the upper surface of the substrate 10. Specifically, the part of the second touch planarization layer 185 provided as an organic insulating layer in the moisture penetration prevention area NDA2 is extended toward the substrate 10 between the two moisture penetration prevention structures WPS1 and WPS2 to be disposed in contact with the upper surface of the substrate 10. Accordingly, since the organic insulating layer formed of only one layer is disposed on the opening 11, layer peeling due to a laser emitted for forming the light-transmissive area TA may be more effectively prevented.

In addition, the display panel according to the third embodiment is different from the display panel according to the second embodiment in that the touch insulating layer 183 of the display area DA is extended to the non-display area NDA to increase the height of the moisture penetration prevention structure WPS. Accordingly, the display panel according to the third embodiment increases the length of a path through which oxygen, moisture, or the like penetrates by increasing the height of the moisture penetration prevention structure WPS, thereby more effectively blocking oxygen, moisture, or the like entering through the light-transmissive area TA. In such a case, unlike the display panel according to the second embodiment, since the display panel according to the third embodiment does not dispose the first touch planarization layer 181 and the touch buffer layer 182 in the non-display area NDA, the touch insulating layer 183 may be disposed on the encapsulation layer 173 in contact with the second encapsulation layer 173. The second touch planarization layer 185 may be disposed on the touch insulating layer 183.

In describing the display panel according to the third embodiment, the same components as those of the display panel according to the first embodiment and the display panel according to the second embodiment may be denoted by the same reference numerals, and therefore detailed description thereof will be omitted or briefly given.

Referring to FIGS. 2, 3, 7, and 16, the display panel 100 according to an example embodiment of the present disclosure may include the display area DA, the light-transmissive area TA, and the non-display area NDA surrounding the light-transmissive area TA. The non-display area NDA may include the wire area NDA1, the moisture penetration prevention area NDA2, and the dummy area NDA3. The display panel 100 may include the substrate 10 disposed in the display area DA and the non-display area NDA, the circuit part 13 disposed on the substrate 10, the light-emitting element part 15 disposed on the circuit part 13, the encapsulation part 17 disposed on the light-emitting element part 15, and the touch part 18 disposed on the encapsulation part 17. In such a case, in the non-display area NDA, the substrate 10 and the encapsulation part 17 include the opening 11 disposed corresponding to the light-transmissive area TA, and an organic insulating layer is disposed between two moisture penetration prevention structures WPS separated from an upper part of the opening 11. The organic insulating layer may be formed by extending the second touch planarization layer 185 among the plurality of layers constituting the touch part 18 toward the light-transmissive area TA, without being limited thereto.

Referring to FIG. 16, the moisture penetration prevention area NDA2 may have various structures for preventing moisture penetration, and the display panel according to the third embodiment may more effectively respond to moisture penetration by using two moisture penetration prevention structures WPS spaced apart from each other and an organic insulating layer disposed between the two moisture penetration prevention structures WPS.

Referring to FIGS. 16 and 17, the moisture penetration prevention structure WPS disposed on the display panel according to the third embodiment is formed on the substrate 10 to have a predetermined height, and includes the first moisture penetration prevention structure WPS 1 and the second moisture penetration prevention structure WPS2 spaced apart from each other. However, the present disclosure is not limited thereto, and the moisture penetration prevention structure WPS may include two or more structures spaced apart from each other. In addition, the first moisture penetration prevention structure WPS1 and the second moisture penetration prevention structure WPS2 separated into two may be formed to have the same height and the same buffer layer, insulating layer, metal layer, or the like, but are not necessarily limited thereto.

The first moisture penetration prevention structure WPS 1 and the second moisture penetration prevention structure WPS2 may each include the support layer SL, and the plurality of protruding patterns ST disposed to be spaced apart from each other on the support layer SL, the light-emitting stack 152 that is not continuously formed by the plurality of protruding patterns ST disposed to be spaced apart from each other, and the inorganic insulating layer disposed on the plurality of protruding patterns ST where the light-emitting stack 152 is disposed. In addition, the first moisture penetration prevention structure WPS1 and the second moisture penetration prevention structure WPS2 may each include a part or a dummy layer disposed on the inorganic insulating layer and extending from the touch insulating layer 183 of the touch part 18.

The first moisture penetration prevention structure WPS1 may further include the dam DAM disposed on the support layer SL. The plurality of protruding patterns ST may be disposed on the support layer SL while being spaced apart from each other. In such a case, the protruding pattern ST disposed on the first moisture penetration prevention structure WPS1 may include the plurality of first protruding patterns ST1 disposed on the display area DA side and the plurality of second protruding patterns ST2 disposed on the light-transmissive area TA side with respect to the dam DAM. For example, the dam DAM may be disposed between the plurality of first protruding patterns ST1 and the plurality of second protruding patterns ST2.

The second moisture penetration prevention structure WPS2 may be disposed between the first moisture penetration prevention structure WPS 1 and the dummy area NDA3, and may be disposed in the moisture penetration prevention area NDA2 to be spaced apart from the first moisture penetration prevention structure WPS1.

The second moisture penetration prevention structure WPS2 having a predetermined height on the substrate 10 may form a step structure at the boundary between the moisture penetration prevention area NDA2 and the dummy area NDA3. Such a step structure may prevent the penetration of moisture, oxygen, or the like that may enter through the light-transmissive area TA. In such a case, since the second moisture penetration prevention structure WPS2 disposed on the display panel according to the third embodiment further includes the touch insulating layer 183 compared to the second moisture penetration prevention structure WPS2 disposed on the display panel according to the second embodiment, the height difference in the step structure by the second moisture penetration prevention structure WPS2 increases, thereby more effectively responding to moisture penetration.

In addition, the second moisture penetration prevention structure WPS2 may include a plurality of protruding patterns ST, and the protruding pattern ST disposed on the second moisture penetration prevention structure WPS2 may be referred to as a third protruding pattern ST3. Accordingly, the plurality of protruding patterns ST may include the first protruding pattern ST1 and the second protruding pattern ST2 disposed on the first moisture penetration prevention structure WPS1 with the dam DAM interposed therebetween, and the third protruding pattern ST3 separated from the first protruding pattern ST1 and the second protruding pattern ST2 by an organic insulating layer disposed between the two moisture penetration prevention structures WPS1 and WPS2. The third protruding pattern ST3 may have the same shape as the plurality of first protruding patterns ST1 and the plurality of second protruding patterns ST2, but is not necessarily limited thereto. For example, the first protruding pattern ST1 and the second protruding pattern ST2 may have the same shape, but since the third protruding pattern ST3 is disposed adjacent to the light-transmissive area TA, the third protruding pattern ST3 may be formed to have a different shape from the first protruding pattern ST1. The plurality of first protruding patterns ST1, the plurality of second protruding patterns ST2, and the plurality of third protruding patterns ST3 may be variously modified to have a structure capable of disconnecting the light-emitting stack 152. The third protruding patterns ST3 may be disposed between the plurality of second protruding patterns ST2 and the dummy area NDA3.

The display panel according to the third embodiment may include an organic insulating layer disposed between the first moisture penetration prevention structure WPS 1 and the second moisture penetration prevention structure WPS2, and the organic insulating layer may be formed by extending downward the second touch planarization layer 185 of the touch part 18 extending toward the light-transmissive area TA. Specifically, the second touch planarization layer 185 of the touch part 18 may extend downward between the first moisture penetration prevention structure WPS1 and the second moisture penetration prevention structure WPS2. Accordingly, the organic insulating layer disposed between the first moisture penetration prevention structure WPS1 and the second moisture penetration prevention structure WPS2 may be referred to as a protrusion, and may be referred to as a second protrusion P2 to be distinguished from the first protrusion P1.

The display panel according to the third embodiment may improve the moisture penetration prevention effect by disposing the second protrusion P2 of the organic insulating layer between the first moisture penetration prevention structure WPS 1 and the second moisture penetration prevention structure WPS2 spaced apart from each other.

The dummy area NDA3 may be an area formed for a margin when the substrate 10 is subjected to etching and/or laser cutting. However, when there is no dummy area NDA3, the moisture penetration prevention area NDA2 may be damaged during laser cutting, making it vulnerable to moisture penetration. For example, by disposing the second touch planarization layer 185 extending from the touch part 18 and the opening 11 on the emission line of a laser emitted in order to form the light-transmissive area TA, damage such as layer peeling due to laser cutting may be minimized.

The opening 11 may be formed in the substrate 10 disposed in the dummy area NAD3 to correspond to the light-transmissive area TA, and the side coating layer 31 may be formed in the opening 11. Subsequently, the second touch planarization layer 185, which is one layer extending from the touch part 18, may be disposed on the side coating layer 31 and bonded to the side coating layer 31 to form a robust structure against damage such as layer peeling. Subsequently, the back coating layer 32 may be disposed under the substrate 10 and under the side coating layer 31, without being limited thereto. However, the present disclosure is not necessarily limited thereto, and the back coating layer 32 may be formed only on the lower surface of the substrate 10. Specifically, the lower surfaces of the side coating layer 31 and the back coating layer 32 may be concavely formed toward the anti-etching layer, but is not necessarily limited thereto.

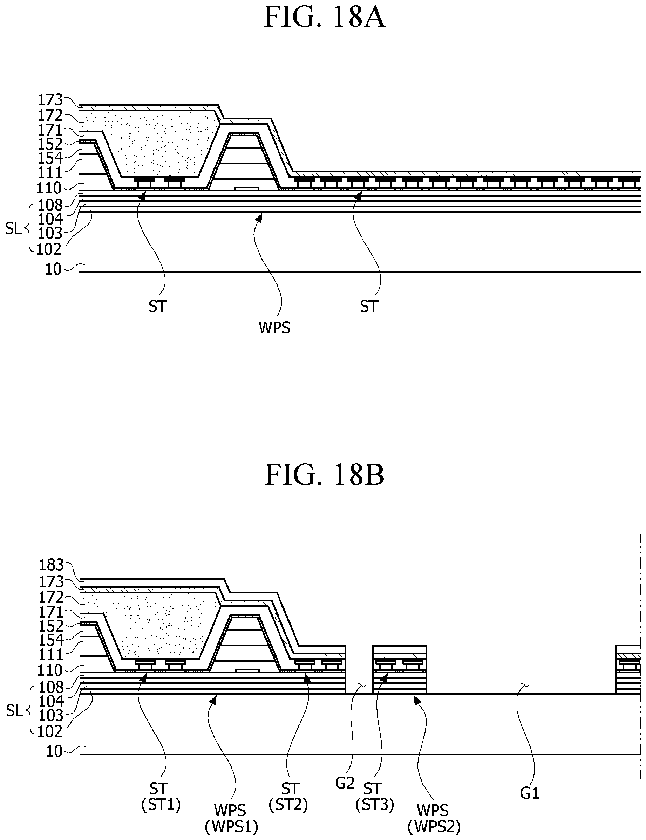

FIGS. 18A to 18H are views illustrating a process of forming a light-transmissive area in the display panel according to the third embodiment of the present disclosure.

FIG. 18A is a view illustrating a step of forming a support layer, a protruding pattern and a dam disposed on the support layer, a light-emitting stack disposed on the protruding pattern and the dam, and an inorganic insulating layer disposed on the light-emitting stack.

Referring to FIG. 18A, the support layer SL may be formed on the substrate 10, and the dam DAM and the plurality of protruding patterns ST may be formed on the support layer SL. Subsequently, the light-emitting stack 152 may be formed on the protruding pattern ST having an undercut shape. Accordingly, the light-emitting stack 152 may not be continuously formed and may be disconnected between the plurality of protruding patterns ST. Subsequently, an inorganic insulating layer may be formed on the dam DAM and the plurality of protruding patterns ST on which the light-emitting stack 152 is disposed. The inorganic insulating layer may be a layer made of an inorganic insulating material formed by extending the first encapsulation layer 171 and the second encapsulation layer 173 of the encapsulation part 17. In such a case, the inorganic insulating layer may be formed of only one of the first encapsulation layer 171 and the second encapsulation layer 173.

FIG. 18B is a view illustrating a step of forming a groove corresponding to the dummy area and a groove separating the moisture penetration prevention structure.

Referring to FIG. 18B, the groove G1 corresponding to the dummy area NDA3 and the groove G2 separating the moisture penetration prevention structure WPS into the first moisture penetration prevention structure WPS1 and the second moisture penetration prevention structure WPS2 may be formed using a laser or the like. The groove G1 corresponding to the dummy area NDA3 may be referred to as a first groove, and the groove G2 separating the moisture penetration prevention structure WPS into the first moisture penetration prevention structure WPS1 and the second moisture penetration prevention structure WPS2 may be referred to as a second groove.

The first groove G1 and the second groove G2 may each be formed in a closed loop shape, and as the first groove G1 is formed, a step structure may be formed at the boundary between the moisture penetration prevention area NDA2 and the dummy area NDA3. Such a step structure may prevent the penetration of moisture, oxygen, or the like that may enter through the light-transmissive area TA. As the second groove G2 is formed, the moisture penetration prevention structure WPS may be separated into two. In such a case, the second moisture penetration prevention structure WPS2 may include the support layer SL, the third protruding pattern ST3 disposed on the support layer SL, the light-emitting stack 152 disposed to be disconnected by the third protruding pattern ST3, the inorganic insulating layer disposed on the third protruding pattern ST3 where the light-emitting stack 152 is disposed, and the touch insulating layer 183 disposed on the inorganic insulating layer.

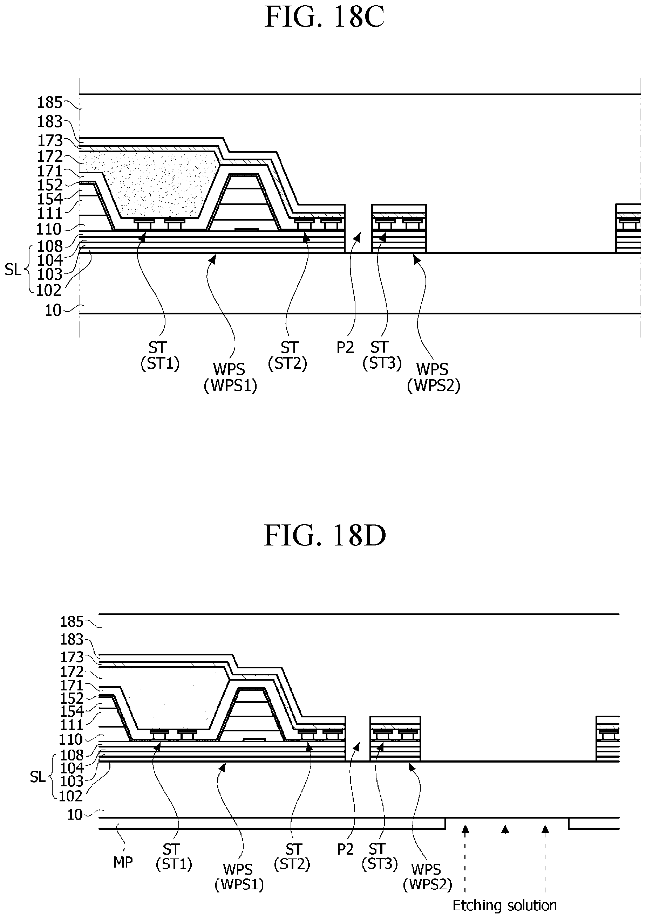

FIG. 18C is a view illustrating a step of forming an organic insulating layer in the first groove and the second groove.

Referring to FIG. 18C, the organic insulating layer may be disposed in the first groove G1 and the second groove G2. In such a case, the organic insulating layer may be on the inorganic insulating layer. The organic insulating layer may be formed by extending the second touch planarization layer 185 among the layers constituting the touch part 18. For example, when the second touch planarization layer 185 extending from the display area DA is disposed on the touch insulating layer 183, a part of the second touch planarization layer 185 extending from the display area DA may also be disposed in the first groove G1 and the second groove G2. The part of the second touch planarization layer 185 disposed in the second groove G2 may be referred to as the second protrusion P2. The organic insulating layer may be formed by extending the second touch planarization layer 185 among the plurality of layers constituting the touch part 18 toward the light-transmissive area TA, without being limited thereto.

FIG. 18D is a view illustrating a step of disposing a mask pattern on the back surface of the substrate.

Referring to FIG. 18D, the mask pattern MP may be formed under the substrate 10. According to an example embodiment, the mask pattern may be formed according to the number and shape of openings to be formed in the substrate 10 and exposed to an etching solution to simultaneously form a plurality of openings. The example embodiment describes an example in which an etching process is performed using the mask pattern MP, but is not necessarily limited thereto. For example, without placing the mask pattern MP on the back surface of the substrate 10, the etching process may be performed after emitting a laser at a position where the opening 11 is expected to be formed. Accordingly, one area of the substrate 10 irradiated with the laser may react more to an etching solution than another area to form the opening 11.

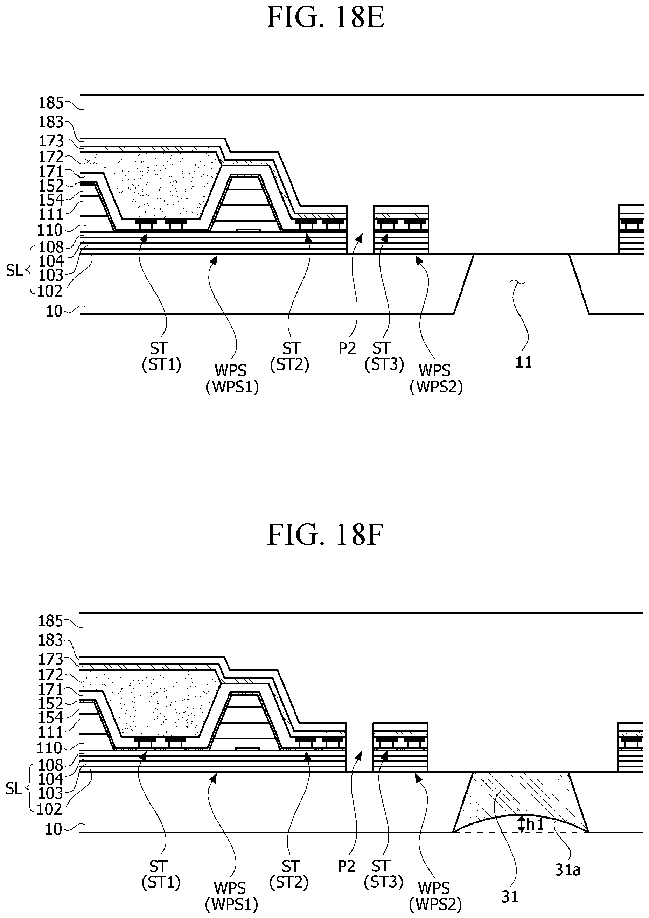

FIG. 18E is a view illustrating a step of forming an opening on the back surface of the substrate through an etching process.

Referring to FIG. 18E, when an etching solution is brought into contact with an exposed area of the substrate 10, a partial area of the back surface of the substrate 10 exposed between the mask patterns MP may be etched to form an opening 11. The substrate 10 may surround the opening 11.

Subsequently, the second touch planarization layer 185 disposed on the opening 11 and serving as an organic insulating layer may prevent the etching solution from penetrating into the interior of the display panel 100. The organic insulating layer disposed on the opening 11 may be formed together when the second touch planarization layer 185 of the display area DA is formed, thereby implementing process optimization.

FIG. 18F is a view illustrating a step of disposing a side coating layer in the opening.

Referring to FIG. 18F, the opening 11 of the substrate 10 may be filled with the side coating layer 31. Subsequently, when the side coating layer 31 is cured, the side coating layer 31 may shrink by a certain height h1 and a curvature may be formed on the lower surface 31a of the side coating layer 31. However, the side coating layer 31 may not shrink depending on a material. For example, the lower surface 31a of the side coating layer 31 may be substantially flat even after curing is completed.

In addition, the side coating layer 31 may be cured and bonded to the second touch planarization layer 185 serving as an organic insulating layer. Accordingly, the bonding may prevent layer peeling from occurring around the light-transmissive area TA and prevent moisture, oxygen, or the like from penetrating into the interior of the display panel 100 through the light-transmissive area TA.

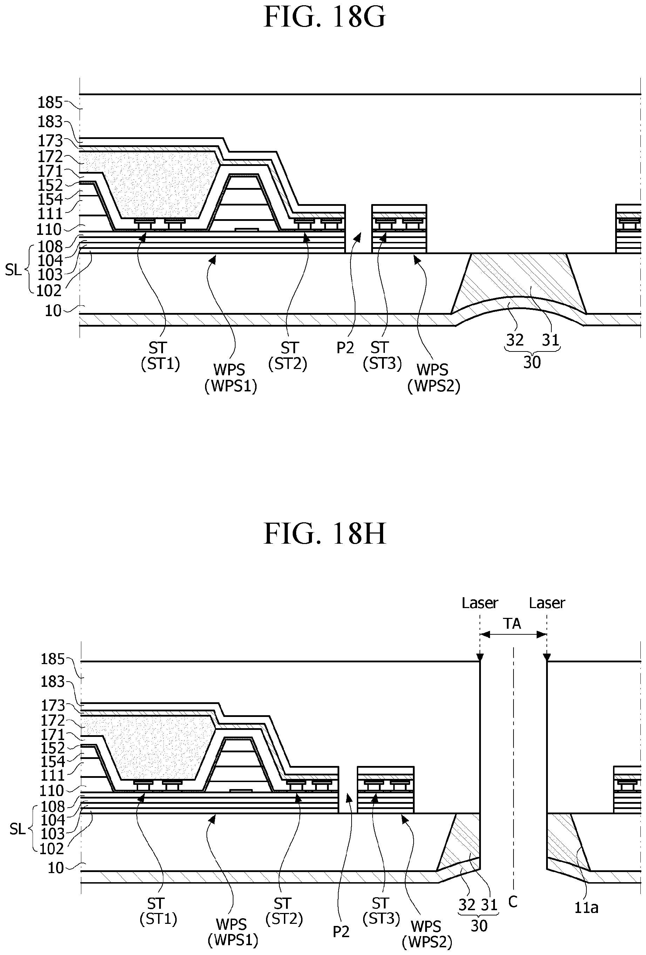

FIG. 18G is a view illustrating a step of disposing a back coating layer.

Referring to FIG. 18G, the back coating layer 32 may be entirely formed on the back surface as the lower surface of the substrate 10 and the back surface of the side coating layer 31. Specifically, a lower surface of the back coating layer 32 may be concavely formed toward the anti-etching layer, but is not necessarily limited thereto. However, the present disclosure is not necessarily limited thereto, and the back coating layer 32 may be formed only on the lower surface of the substrate 10.

FIG. 18H is a view illustrating a laser cutting step.

Referring to FIG. 18H, the light-transmissive area TA may be formed by irradiating the opening 11 side of the substrate 10 with a laser. In such a case, the organic insulating layer, the side coating layer 31, or the like may be cut by a laser. Since the display device according to an example embodiment of the present disclosure includes bonding of the side coating layer 31 and the second touch planarization layer 185 and an inorganic insulating layer that is not disposed in the dummy area NDA3, peeling of the inorganic insulating layer due to laser irradiation may be prevented. In addition, in the display device according to an example embodiment of the present disclosure, layer peeling due to a laser emitted for forming the light-transmissive area TA may be more effectively prevented through bonding of the organic insulating layer formed of only one layer on the opening 11 and the side coating layer 31 disposed within the opening 11.

The display device according to one or more embodiments of the present disclosure may be described as follows.

A display device according to one or more embodiments of the present disclosure may include: a display panel including a display area, a light-transmissive area, and a non-display area adjacent to (e.g., surrounding) the light-transmissive area, wherein the display panel may include: a substrate disposed in the display area and the non-display area; a circuit part disposed on the substrate; a light-emitting element part disposed on the circuit part; an encapsulation part disposed on the light-emitting element part; and a touch part disposed on the encapsulation part, wherein the substrate and the encapsulation part surround an opening disposed corresponding to the light-transmissive area, and an organic insulating layer is disposed on the opening.

The organic insulating layer may be one of a first touch planarization layer and a second touch planarization layer extending from the touch part toward the light-transmissive area.

An end portion of an inorganic insulating layer extending from the encapsulation part toward the light-transmissive area may be exposed to the opening.

The inorganic insulating layer may be one of a first encapsulation layer and a second encapsulation layer extending from the encapsulation part toward the light-transmissive area.

The non-display area may include a wire area where a wire that bypasses the light-transmissive area is disposed, a dummy area surrounding the light-transmissive area, and a moisture penetration prevention area disposed between the wire area and the dummy area, a moisture penetration prevention structure disposed on the substrate to have a predetermined height may be disposed in the moisture penetration prevention area, and the inorganic insulating layer may cover a side surface of the moisture penetration prevention structure.

The moisture penetration prevention structure may include a support layer and a plurality of protruding patterns disposed on the support layer while being spaced apart from each other, and each of the plurality of protruding patterns may have an undercut shape.

An inorganic insulating layer may be disposed between the plurality of protruding patterns. In such a case, the inorganic insulating layer may cover the protruding patterns.

The plurality of protruding patterns may be formed to have the same layer structure as a source electrode of the circuit part and/or may be located on the same layer as the source electrode of the circuit part.

The moisture penetration prevention structure may further include a dam, and the plurality of protruding patterns may include a plurality of first protruding patterns disposed between the display area and the dam, and a plurality of second protruding patterns disposed between the dam and the dummy area.

The non-display area may include a wire area where a wire that bypasses the light-transmissive area is disposed, a dummy area surrounding the light-transmissive area, and a moisture penetration prevention area disposed between the wire area and the dummy area, and in the dummy area, the inorganic insulating layer may be in contact with an upper surface of the substrate.

The non-display area may include a wire area where a wire that bypasses the light-transmissive area is disposed, a dummy area surrounding the light-transmissive area, and a moisture penetration prevention area disposed between the wire area and the dummy area, two moisture penetration prevention structures disposed on the substrate to have a predetermined height while being spaced apart from each other may be disposed in the moisture penetration prevention area, and the organic insulating layer may be disposed between the two moisture penetration prevention structures to be in contact with an upper surface of the substrate.

At least one of the two moisture penetration prevention structures may further include a dam, the display device may further include a plurality of protruding patterns that may include a first protruding pattern and a second protruding pattern disposed while interposing the dam therebetween, and a third protruding pattern separated from the first protruding pattern and the second protruding pattern, and the third protruding pattern may be separated from the first protruding pattern and the second protruding pattern by the organic insulating layer disposed between the two moisture penetration prevention structures.

The non-display area may include a wire area where a wire that bypasses the light-transmissive area is disposed, a dummy area surrounding the light-transmissive area, and a moisture penetration prevention area disposed between the wire area and the dummy area, and in the dummy area, the first touch planarization layer or the second touch planarization layer may be in contact with an upper surface of the substrate.

The display device may further include a coating layer disposed in the opening, wherein an upper part of the coating layer is in contact with the organic insulating layer. Consequently, the organic insulating layer and the coating layer may be disposed to surround the light-transmissive area.

A display device according to one or more embodiments of the present disclosure may include: a display panel including a display area, a light-transmissive area, and a non-display area surrounding the light-transmissive area, wherein the display panel may include: a substrate disposed in the display area and the non-display area; a circuit part disposed on the substrate; a light-emitting element part disposed on the circuit part; an encapsulation part disposed on the light-emitting element part; and a touch part disposed on the encapsulation part, wherein the substrate may include an opening disposed corresponding to the light-transmissive area, and wherein one of a first touch planarization layer and a second touch planarization layer of the touch part extending toward the light-transmissive area may be bonded to a coating layer disposed in the opening (for example, to an upper part of the coating layer).

The non-display area may include a wire area where a wire that bypasses the light-transmissive area is disposed, a dummy area surrounding the light-transmissive area, and a moisture penetration prevention area disposed between the wire area and the dummy area, and in the moisture penetration prevention area, a moisture penetration prevention structure disposed to have a predetermined height may be disposed on the substrate.

The moisture penetration prevention structure may include a support layer and a plurality of protruding patterns disposed on the support layer while being spaced apart from each other, and each of the plurality of protruding patterns may have an undercut shape.

The moisture penetration prevention structure may include a first moisture penetration prevention structure and a second moisture penetration prevention structure spaced apart from each other, and one of the first touch planarization layer and the second touch planarization layer may include a protrusion extending between the first moisture penetration prevention structure and the second moisture penetration prevention structure.

The protrusion may be in contact with an upper surface of the substrate.

A display device according to one or more embodiments of the present disclosure may include: a display panel including a display area, a light-transmissive area, and a non-display area surrounding the light-transmissive area, wherein the display panel may include: a substrate disposed in the display area and the non-display area; a circuit part disposed on the substrate; a light-emitting element part disposed on the circuit part; an encapsulation part disposed on the light-emitting element part; and a touch part disposed on the encapsulation part, wherein the substrate may include an opening disposed corresponding to the light-transmissive area, the non-display area includes a wire area where a wire that bypasses the light-transmissive area is disposed, a dummy area surrounding the light-transmissive area, and a moisture penetration prevention area disposed between the wire area and the dummy area, wherein the moisture penetration prevention area may include a first moisture penetration prevention structure and a second moisture penetration prevention structure spaced apart from each other, and wherein one of a first touch planarization layer and a second touch planarization layer of the touch part extending from the touch part toward the light-transmissive area may be disposed between the first moisture penetration prevention structure and the second moisture penetration prevention structure.

A display device according to one or more embodiments of the present disclosure may include: a display panel including a display area, a light-transmissive area, and a non-display area surrounding the light-transmissive area, wherein the display panel includes: a substrate disposed in the display area and the non-display area; a circuit part disposed on the substrate; a light-emitting element part disposed on the circuit part; an encapsulation part disposed on the light-emitting element part; and a touch part disposed on the encapsulation part, wherein the non-display area includes a wire area where a wire that bypasses the light-transmissive area is disposed, a dummy area surrounding the light-transmissive area, and a moisture penetration prevention area disposed between the wire area and the dummy area, and in the moisture penetration prevention area, a moisture penetration prevention structure disposed to have a predetermined height is disposed on the substrate.

A display panel according to one or more embodiments of the present disclosure may include: a display area, a light-transmissive area, and a non-display area surrounding the light-transmissive area; a substrate disposed in the display area and the non-display area; a circuit part disposed on the substrate; a light-emitting element part disposed on the circuit part; an encapsulation part disposed on the light-emitting element part; and a touch part disposed on the encapsulation part, wherein the substrate and the encapsulation part surround an opening disposed corresponding to the light-transmissive area, and wherein an organic insulating layer is disposed on the opening.

The objects to be achieved by the present disclosure, the means for achieving the objects, and effects of the present disclosure described above do not specify essential features of the claims, and thus, the scope of the claims is not limited to the disclosure of the present disclosure.

Although the example embodiments of the present disclosure have been described in more detail with reference to the accompanying drawings, the present disclosure is not limited thereto and may be embodied in many different forms without departing from the technical concept of the present disclosure. Therefore, the exemplary embodiments disclosed in the present disclosure are provided for illustrative purposes only and are not intended to limit the technical concept of the present disclosure. The scope of the technical concept of the present disclosure is not limited thereto. Therefore, it should be understood that the above-described embodiments are illustrative in all aspects and do not limit the present disclosure.

### [Description of Reference Numerals]

| | | | |
|---|---|---|---|
| 10: | Substrate | 11: | Opening |
| 13: | Circuit part | 15: | Light-emitting element part |

| | | | |
|---|---|---|---|
| 17: | encapsulation part | 18: | Touch part |
| 30: | Coating layer | 100: | Display panel |
| 171: | First encapsulation layer | 172: | Second encapsulation layer |
| 181: | First touch planarization layer | | |
| 185: | Second touch planarization layer | | |
| 110: | First planarization layer | | |

| | | | |
|---|---|---|---|
| DA: | Display area | NDA: | Non-display area |
| P1: | First protrusion | P2: | Second protrusion |
| ST: | Protruding pattern | TA: | Light-transmissive area |
| WPS: | moisture penetration prevention structure | | |

## Claims

1. A display device comprising:
a display panel (100) including a display area (DA), a light-transmissive area (TA), and a non-display area (NDA) adjacent to the light-transmissive area (TA),
wherein the display panel (100) comprises:
a substrate (10) disposed in the display area (DA) and the non-display area (NDA);
a circuit part (13) disposed on the substrate (10);
a light-emitting element part (15) disposed on the circuit part (13);
an encapsulation part (17) disposed on the light-emitting element part (15); and
a touch part (18) disposed on the encapsulation part (17),
wherein the substrate (10) and the encapsulation part (17) surround an opening (11) disposed corresponding to the light-transmissive area (TA), and
wherein an organic insulating layer is disposed on the opening (11).

2. The display device of claim 1, wherein the organic insulating layer is one of a first touch planarization layer (181) and a second touch planarization layer (185) extending from the touch part (18) toward the light-transmissive area (TA).

3. The display device of claim 2, wherein an end portion of an inorganic insulating layer extending from the encapsulation part (17) toward the light-transmissive area (TA) is exposed to the opening (11).

4. The display device of claim 3, wherein the inorganic insulating layer is one of a first encapsulation layer (171) and a second encapsulation layer (173) extending from the encapsulation part (17) toward the light-transmissive area (TA).

5. The display device of claim 3 or 4, wherein:
the non-display area (NDA) includes a wire area (NDA1) where a wire that bypasses the light-transmissive area (TA) is disposed, a dummy area (NDA3) surrounding the light-transmissive area (TA), and a moisture penetration prevention area (NDA2) disposed between the wire area (NDA1) and the dummy area (NDA3),
a moisture penetration prevention structure (WPS) disposed on the substrate (10) to have a predetermined height is disposed in the moisture penetration prevention area (NDA2), and
the inorganic insulating layer covers a side surface of the moisture penetration prevention structure (WPS).

6. The display device of claim 5, wherein:
the moisture penetration prevention structure (WPS) includes a support layer (SL) and a plurality of protruding patterns (ST) disposed on the support layer (SL) while being spaced apart from each other, and
each of at least one of the plurality of protruding patterns (ST) has an undercut shape.

7. The display device of claim 6, wherein an inorganic insulating layer is disposed between the plurality of protruding patterns (ST) with the undercut shapes.

8. The display device of claim 6 or 7, wherein the plurality of protruding patterns (ST) are located on the same layer as a source electrode of the circuit part (13).

9. The display device of any of claims 6 to 8, wherein the moisture penetration prevention structure (WPS) further includes a dam (DAM), and
wherein the plurality of protruding patterns (ST) include:
a plurality of first protruding patterns (ST1) disposed between the display area (DA) and the dam (DAM); and
a plurality of second protruding patterns (ST2) disposed between the dam (DAM) and the dummy area (NDA3).

10. The display device of claim 3 or 4, wherein:
the non-display area (NDA) includes a wire area (NDA1) where a wire that bypasses the light-transmissive area (TA) is disposed, a dummy area (NDA3) surrounding the light-transmissive area (TA), and a moisture penetration prevention area (NDA2) disposed between the wire area (NDA1) and the dummy area (NDA3), and
in the dummy area (NDA3), the inorganic insulating layer is in contact with an upper surface of the substrate (10).

11. The display device of any of claims 1 to 4, wherein:
the non-display area (NDA) includes a wire area (NDA1) where a wire that bypasses the light-transmissive area (TA) is disposed, a dummy area (NDA3) surrounding the light-transmissive area (TA), and a moisture penetration prevention area (NDA2) disposed between the wire area (NDA1) and the dummy area (NDA3),
two moisture penetration prevention structures (WPS) disposed on the substrate (10) to have a predetermined height while being spaced apart from each other are disposed in the moisture penetration prevention area (NDA2), and
the organic insulating layer is disposed between the two moisture penetration prevention structures (WPS) to be in contact with an upper surface of the substrate (10).

12. The display device of claim 11, wherein:
at least one of the two moisture penetration prevention structures (WPS) further includes a dam (DAM),
the display device further includes a plurality of protruding patterns (ST) that include a first protruding pattern (ST1) and a second protruding pattern (ST2) disposed while interposing the dam (DAM) therebetween, and a third protruding pattern (ST3) separated from the first protruding pattern (ST1) and the second protruding pattern (ST2), and
the third protruding pattern (ST3) is separated from the first protruding pattern (ST1) and the second protruding pattern (ST2) by the organic insulating layer disposed between the two moisture penetration prevention structures (WPS).

13. The display device of any of claims 2 to 4, wherein:
the non-display area (NDA) includes a wire area (NDA1) where a wire that bypasses the light-transmissive area (TA) is disposed, a dummy area (NDA3) surrounding the light-transmissive area (TA), and a moisture penetration prevention area (NDA2) disposed between the wire area (NDA1) and the dummy area (NDA3), and
in the dummy area (NDA3), the first touch planarization layer (181) or the second touch planarization layer (185) is in contact with an upper surface of the substrate (10).

14. The display device of any of claims 1 to 13, further comprising:
a coating layer (30) disposed in the opening (11),
wherein an upper part of the coating layer (30) is in contact with the organic insulating layer.
